# EUROPÄISCHE PATENTANMELDUNG

(11) **EP 3 666 783 A1**
(43) Veröffentlichungstag der Anmeldung: **17.06.2020**
(21) Anmeldenummer: 18212064.2
(22) Anmeldetag: 12.12.2018
(51) Int. Cl.: C07F 11/00, C23C 16/34, H01L 21/768

(54) **VERFAHREN ZUR HERSTELLUNG VON BIS(TERT-BUTYLIMIDO)BIS(DIALKYLAMIDO)WOLFRAM-VERBINDUNGEN, BIS(TERT-BUTYLIMIDO)BIS(DIALKYLAMIDO)WOLFRAM-VERBINDUNGEN, VERWENDUNG EINER BIS(TERT-BUTYLIMIDO)BIS(DIALKYLAMIDO)WOLFRAM-VERBINDUNG UND SUBSTRAT**

(71) Anmelder: UMICORE AG & CO. KG, 63457 Hanau-Wolfgang (DE)
(72) Erfinder: PULZ, Susanne, 35037 Marburg (DE); SUNDERMEYER, Joerg, 35041 Marburg (DE); RIVAS NASS, Andreas, 64625 Bensheim (DE); BRIEL, Oliver, 63755 Alzenau (DE); KARCH, Ralf, 63801 Kleinostheim (DE); SCHORN, Wolf, 76337 Waldbronn (DE); FREY, Annika, 63457 Hanau (DE); DOPPIU, Angelino, 63500 Seligenstadt (DE); WOERNER, Eileen, 61130 Nidderau (DE)
(74) Vertreter: Clauswitz, Kai-Uwe Wolfram

(57) **Zusammenfassung**

Die Erfindung betrifft eine zweistufige Synthese zur Herstellung von Bis(*tert-*butylimido)bis(dialkylamido)wolfram-Verbindungen gemäß der allgemeinen Formel [W(N*t*Bu)₂(NR^{A}R^{B})₂] (I) betrifft, ausgehend von [W(N*t*Bu)₂(NH*t*Bu)₂], Die Erfindung betrifft weiterhin Verbindungen gemäß der allgemeinen Formel [W(N*t*Bu)₂(NR^{A}R^{B})₂] (I), erhältlich nach dem beanspruchten Verfahren, Verbindungen gemäß der allgemeinen Formel [W(N*t*Bu)₂(NR^{A}R^{B})₂] (I), mit Ausnahme von [W(N*t*Bu)₂(NMe₂)₂] und [W(N*t*Bu)₂(NEtMe)₂], die Verwendung einer Verbindung [W(N*t*Bu)₂(NR^{A}R^{B})₂] (I) sowie ein Substrat, welches auf einer Oberfläche eine Wolfram-Schicht oder eine Wolfram enthaltende Schicht aufweist. Mit dem beschriebenen Verfahren sind definierte Bis(*tert-*butylimido)bis(dialkylamido)wolfram-Verbindungen des Typs [W(N*t*Bu)₂(NR^{A}R^{B})₂] (I) auf einfache, kostengünstige und reproduzierbare Weise in hoher Reinheit und guten Ausbeuten darstellbar. Sie eignen sich aufgrund ihrer hohen Reinheit als Präkursoren zur Herstellung qualitativ hochwertiger Substrate, welche Wolfram-Schichten oder Wolfram enthaltende Schichten aufweisen.

## Beschreibung

Die Erfindung betrifft ein Verfahren zur Herstellung von Verbindungen gemäß der allgemeinen Formel [W(N*t*Bu)₂(NR^{A}R^{B})₂], welche im Folgenden auch Bis(*tert*-butylimido)bis(dialkylamido)wolfram-Verbindungen oder Bis(*tert-*butylimido)bis(dialkylamido)wolfram-Komplex genannt werden. Dabei sind R^{A} und R^{B} unabhängig voneinander ausgewählt aus der Gruppe bestehend aus linearen und verzweigten Alkylresten mit 1 bis 20 Kohlenstoffatomen. Gegenstand der Erfindung sind zudem Verbindungen gemäß der allgemeinen Formel [W(N*t*Bu)₂(NR^{A}R^{B})₂], erhältlich nach dem beanspruchten Verfahren, Verbindungen gemäß der allgemeinen Formel [W(N*t*Bu)₂(NR^{A}R^{B})₂], mit Ausnahme von [W(N*t*Bu)₂(NMe₂)₂] und [W(N*t*Bu)₂(NEtMe)₂], die Verwendung einer Verbindung [W(N*t*Bu)₂(NR^{A}R^{B})₂] sowie ein Substrat, welches auf einer Oberfläche eine Wolfram-Schicht oder eine Wolfram enthaltende Schicht aufweist.

Wolframschichten sowie Wolfram enthaltende Schichten sind unter anderem in der Halbleiter-, Solar, TFT-LCD- und Flachbildschirmtechnologie von Bedeutung. Wolframnitrid-Schichten stellen beispielsweise gute Kupferdiffusionsbarrieren für mikroelektronische Bauteile dar. Aufgrund seines geringen elektrischen Widerstandes und seiner Beständigkeit auf Kupfer stellt Wolframnitrid ein vergleichsweise vielversprechendes Barrierematerial dar. Dünne Wolframnitrid-Filme können auch als Elektroden für Dünnschichtkondensatoren und Feldeffekttransistoren eingesetzt werden.

In der Halbleiterindustrie wird insbesondere das Aufwachsen von Wolframnitrid-Schichten mit einem niedrigen spezifischen Widerstand und einer ausgezeichneten Stufenabdeckung angestrebt. Zur Herstellung solcher Wolframnitrid-Schichten, anderer Wolfram enthaltender Schichten, wie z. B. von Schichten oder Filmen von WCN, WSi, WSiN und WO, sowie reiner Wolframschichten werden üblicherweise Gasphasenabscheidungsmethoden eingesetzt. Am häufigsten werden unterschiedliche ALD-Verfahren (engl. *Atomic Layer Deposition*) und CVD-Methoden (engl. *Chemical Vapour Deposition)* genutzt.

An dieser Stelle sowie im Folgenden wird auf die Angabe einer exakten Stöchiometrie der abscheidbaren Wolfram enthaltenden Schichten oder Filme verzichtet. Außerdem wird der Begriff Schicht gleichbedeutend mit dem Ausdruck Film verwendet und trifft keine Aussage über die Schichtdicke oder die Filmdicke.

Die Abscheidung von Wolframnitrid-Schichten mittels eines ALD-Verfahrens wurde beispielsweise im Jahr von 2000 Klaus *et al.* beschrieben. (J. W. Klaus, S. J. Ferro, S. M. George, J. Electrochem. Soc. 2000, 147, 1175 - 1181) Ausgehend von WF₆ und NH₃ wurden Wolframnitrid-Schichten mit einer guten Stufenabdeckung erhalten. Nachteilig an dieser Methode ist jedoch, dass WF₆ und/oder das während des Prozesses anfallende Nebenprodukt Fluorwasserstoff insbesondere Substrate angreift, die aus Silicium bestehen oder Silicium enthalten. Zudem können Fluorverunreinigungen auf der Oberfläche der Wolframnitrid-Schicht die später gewünschte Anhaftung von Kupfer negativ beeinflussen.

Als halogenfreier Präkursor für die Abscheidung von Wolframnitrid-Schichten ist im Stand der Technik beispielsweise die Bis(alkylimido)bis(dialkylamido)wolfram-Verbindung [W(N*t*Bu)₂(NMe₂)₂] bekannt. Im Jahr 2003 berichteten Becker *et al.* über ihre Synthese und Anwendung als Präkursor in einem ALD-Verfahren. (J. S. Becker, S. Suh, S. Wang, R. G. Gordon, Chem. Mater. 2003, 15, 2969 - 2976)

Die von Becker *et al.* publizierte Syntheseroute zur Darstellung von [W(N*t*Bu)₂(NMe₂)₂] umfasst drei Stufen und wird von den Autoren analog für die Herstellung von [W(N*t*Bu)₂(NMeEt)₂] angewendet. Zur Herstellung von [W(N*t*Bu)₂(NMe₂)₂] wird im ersten Schritt kommerziell erhältliches WCl₆ mit vier Äquivalenten HN(tBu)(SiMe₃) in Toluol zu einem halben Äquivalent des gemischtsubstituierten *tert*-Butylamin-Addukts [W(N*t*Bu)₂Cl₂(NH₂*t*Bu)]₂ umgesetzt. Zur Isolierung und Aufreinigung dieses ersten Zwischenproduktes sind unter anderem ein Filtrationsschritt zur Abtrennung von (*t*Bu)(Me₃Si)NH₂Cl und nicht umgesetztem WCl₆ sowie eine Kristallisation vorgesehen. Im zweiten Schritt erfolgt die Umsetzung eines halben Äquivalents [W(N*t*Bu)₂Cl₂(NH₂*t*Bu)]₂ mit zwei Äquivalenten Pyridin in Diethylether. Dabei wird das Pyridin-Addukt [W(N*t*Bu)₂Cl₂(py)₂] unter Freisetzung von *tert*-Butylamin (*t*BuNH₂) erhalten. Zur Isolierung dieses zweiten Zwischenproduktes müssen das Lösungsmittel Diethylether, *t*BuNH₂ sowie überschüssiges Pyridin im Vakuum entfernt werden, was aufgrund der hohen Siedetemperatur von Pyridin problematisch ist. Für den dritten und letzten Reaktionsschritt muss zunächst das Edukt Lithiumdimethylamid (LiNMe₂) in einer separaten Synthese dargestellt werden. Denn die Zielverbindung [W(N*t*Bu)₂(NMe₂)₂] wird durch die Umsetzung eines Äquivalents [W(N*t*Bu)₂Cl₂(py)₂] mit zwei Äquivalenten LiNMe₂ in Diethylether hergestellt. Dieser dritte Schritt wird als sehr heftig und exotherm beschrieben. Die Aufreinigung des Produkts [W(N*t*Bu)₂(NMe₂)₂] umfasst einen Filtrationsschritt, um die während der Reaktion angefallene LiCI-Fracht sowie überschüssiges LiNMe₂ abzutrennen. Darüber hinaus sind zwei Destillationen unter reduziertem Druck vorgesehen. Die Verbindungen [W(N*t*Bu)₂(NMe₂)₂] und [W(N*t*Bu)₂(NEtMe)₂] werden jeweils als blassgelbe Flüssigkeit beschrieben. Über die jeweilige Gesamtausbeute wird in der Literatur keine Angabe gemacht.

Ein wesentlicher Nachteil der bekannten Prozessführung zur Herstellung der Bis(alkylimido)bis(dialkylamido)wolfram-Verbindung [W(N*t*Bu)₂(NMe₂)₂] besteht in der Vielzahl der Reaktionsschritte und dem mit jeder der drei Synthesestufen verbundenen Arbeits- und Zeitaufwand. Es werden zwei Zwischenprodukte, nämlich [W(N*t*Bu)₂Cl₂(NH₂*t*Bu)]₂ und [W(N*t*Bu)₂Cl₂(py)₂], dargestellt und isoliert. Dabei umfasst ihre Isolierung und/oder Aufreinigung jeweils wenigstens einen zeit- und/oder arbeitsintensiven Schritt. Zudem ist für die dritte Synthesestufe das Edukt LiNMe₂ in einer separaten Reaktion herzustellen. Weiterhin nachteilig ist, dass unter anderem die grundsätzlich zur Koordination befähigten Lösungsmittel Diethylether und Pyridin zum Einsatz kommen. Insbesondere im dritten Schritt ist die Verwendung von Diethylether als Lösungsmittel nachteilig, weil die Abtrennung der als Nebenprodukt anfallenden LiCI-Fracht sowie des überschüssigen LiNMe₂ dadurch schwierig, zumindest aber erschwert, sein kann. Sind Lithiumionen im Reaktionsgemisch zugegen, kann es außerdem zur Bildung von Lithium-Wolframat-Komplexsalzen kommen, welche ebenfalls schwierig oder gar nicht abtrennbar sind. Mit Blick auf eine industrielle Anwendung von Bis(alkylimido)bis(dialkylamido)wolfram-Verbindungen und eine damit erforderliche Synthese im industriellen Maßstab ist insbesondere der dritte Syntheseschritt unvorteilhaft, zumal er als sehr heftig und exotherm beschrieben wird und somit unter Sicherheitsaspekten zumindest als kritisch einzustufen ist.

Die literaturbekannte Vorschrift sieht außerdem eine aufwändige Aufreinigung des Endprodukts [W(N*t*Bu)₂(NMe₂)₂] beziehungsweise [W(N*t*Bu)₂(NEtMe)₂] durch einen Filtrationsschritt und zwei Destillationen vor. Dennoch kann das so erhaltenen Produkte nicht exakt quantifizierbare Salzverunreinigungen, insbesondere Lithiumverunreinigungen, aufweisen. Mithin können seine Eigenschaften - im Vergleich zu dem Produkt in Reinform - in nicht kontrollierbarer und zum Teil irreversibler Weise verändert bzw. verschlechtert sein. Unbekannt ist, ob mit der vorbeschriebenen Reaktionsführung Ausbeuten erhalten werden, welche mit Blick auf einen industriellen Einsatz dieser Verbindung zufriedenstellend sind.

Insgesamt ist die literaturbekannte Syntheseroute unter ökologischen und ökonomischen Gesichtspunkten als unbefriedigend einzustufen.

Der Erfindung liegt daher die Aufgabe zugrunde, diese und weitere Nachteile des Standes der Technik zu überwinden und ein Verfahren zur Verfügung zu stellen, mit welchem einfach, effizient, kostengünstig und reproduzierbar definierte Bis(alkylimido)bis(dialkylamido)wolfram-Verbindungen in hoher Reinheit und guten Ausbeuten herstellbar sind. Insbesondere soll die Reinheit der mit dem Verfahren darstellbaren Bis(alkylimido)bis(dialkylamido)wolfram-Verbindungen den Anforderungen an Präkursoren zur Herstellung qualitativ hochwertiger Substrate genügen, welche Wolfram-Schichten oder Wolfram enthaltende Schichten aufweisen. Das Verfahren soll sich dadurch auszeichnen, dass es - mit vergleichbarer Ausbeute und Reinheit der Zielverbindungen - auch im industriellen Maßstab durchführbar ist. Zudem sollen neue Bis(alkylimido)bis(dialkylamido)wolfram-Verbindungen bereitgestellt werden. Des Weiteren soll ein Substrat zur Verfügung gestellt werden, welches auf einer Oberfläche eine Wolfram-Schicht oder eine Wolfram enthaltende Schicht aufweist, welche unter Verwendung einer nach dem beanspruchten Verfahren erhältlichen oder erhaltenen Bis(alkylimido)bis(dialkylamido)wolfram-Verbindung herstellbar ist oder unter Verwendung einer der neuen Bis(alkylimido)bis(dialkylamido)wolfram-Verbindungen.

Hauptmerkmale der Erfindung sind in Anspruch 1 oder einem der Ansprüche 22 bis 33 angegeben. Ausgestaltungen sind Gegenstand der Ansprüche 2 bis 21.

Gelöst wird die Aufgabe durch
ein Verfahren zur Herstellung von Bis(tert-butylimido)bis(dialkylamido)wolfram-Verbindungen
gemäß der allgemeinen Formel

[W(N*t*Bu)₂(NR^{A}R^{B})₂] (I),

wobei
R^{A} und R^{B} unabhängig voneinander ausgewählt sind aus der Gruppe bestehend aus linearen und verzweigten Alkylresten mit 1 bis 20 Kohlenstoffatomen,
umfassend die Schritte:
a) Zurverfügungstellung von [W(N*t*Bu)₂(NH*t*Bu)₂]
   und
b) Umsetzung von [W(N*t*Bu)₂(NH*t*Bu)₂] aus Schritt a) mit einem Amin gemäß der allgemeinen Formel HNR^{A}R^{B} in einem Lösungsmittel M_{U},
wobei
- R^{A} und R^{B} unabhängig voneinander ausgewählt sind aus der Gruppe bestehend aus linearen und verzweigten Alkylresten mit 1 bis 20 Kohlenstoffatomen,
   und
- ein molares Verhältnis [W(N*t*Bu)₂(NH*t*Bu)₂] : HNR^{A}R^{B} < 1 : 2 ist.

Dabei umfasst die allgemeine Formel I sowohl die Monomere als auch etwaige Oligomere.

Die Alkylreste R^{A} und R^{B} können auch substituiert sein, z. B. teilweise oder vollständig halogeniert sein.

Das Lösungsmittel M_{U} kann auch ein Lösungsmittelgemisch sein, umfassend zwei oder mehr Lösungsmittel.

Das beanspruchte Verfahren ermöglicht vorteilhafterweise die Darstellung der Zielverbindungen [W(N*t*Bu)₂(NR^{A}R^{B})₂] (I) in einer einfachen zweistufigen Synthese.
Durch Umsetzung eines Moläquivalents der in Schritt a) zur Verfügung gestellten Verbindung [W(N*t*Bu)₂(NH*t*Bu)₂] mit einem Überschuss des Amins HNR^{A}R^{B} in dem Lösungsmittel M_{U} wird in Schritt b) der jeweilige Bis(*tert-*butylimido)bis(dialkylamido)wolfram-Komplex erhalten. Überschuss bedeutet an dieser Stelle, dass mehr als zwei Moläquivalente HNR^{A}R^{B}, welche formal für die Darstellung von [W(N*t*Bu)₂(NR^{A}R^{B})₂] (I) benötigt werden, vorgesehen sind. Das molare Verhältnis [W(N*t*Bu)₂(NH*t*Bu)₂] : HNR^{A}R^{B} ist also kleiner als 1 : 2, d. h. kleiner als 0,5. Dabei hängt die zu wählende Höhe des Überschusses an HNR^{A}R^{B} insbesondere von der Reaktivität des jeweils in Schritt b) als Edukt eingesetzten sekundären Amins selbst ab, insbesondere unter Berücksichtigung der ansonsten gewählten Reaktionsparamater, wie z. B. des Lösungsmittels oder Lösungsmittelgemisches.

Bei der beanspruchten zweistufigen Synthese liegen nach Durchführung des Schrittes b) ausschließlich die gewünschte Bis(*tert*-butylimido)bis(dialkylamido)wolfram-Verbindung des Typs [W(N*t*Bu)₂(NR^{A}R^{B})₂] (I) vor sowie das definierte, vergleichsweise einfach abtrennbare Nebenprodukt *t*BuNH₂ und nicht umgesetztes, d. h. im Überschuss eingesetztes, Amin HNR^{A}R^{B}. Das in Schritt b) anfallende *t*BuNH₂ ist vergleichsweise leicht flüchtig und kann somit auf einfache Weise quantitativ entfernt werden, nämlich durch Anlegen eines geringfügigen Unterdrucks an einen Innenraum des jeweiligen Reaktionsbehältnisses. Dasselbe gilt in der Regel für das in Schritt b) jeweils im Überschuss verwendete HNR^{A}R^{B}, insbesondere für sehr leicht flüchtige Amine, wie z. B. HNMe₂. Weiterhin ist von Vorteil, dass es - aufgrund der Abwesenheit von Lithiumverbindungen, insbesondere LiCI, - nicht zur Bildung undefinierbarer Nebenprodukte kommt, z. B. von Lithium-Wolframat-Komplexsalzen, welche sich nur schwierig oder gar nicht abtrennen lassen. Die jeweilige in Lösung befindliche Zielverbindung des Typs [W(N*t*Bu)₂(NR^{A}R^{B})₂] (I) kann unmittelbar mit einem oder mehreren weiteren Reaktanden umgesetzt werden. Alternativ kann die Verbindung des Typs [W(N*t*Bu)₂(NR^{A}R^{B})₂] (I) beispielsweise einfach durch Entfernen aller flüchtigen Bestandteile isoliert werden. Des Weiteren weist die isolierte Verbindung - gemäß NMR-spektroskopischer Untersuchung - weder Amin-Verunreinigungen noch Reste des verwendeten Lösungsmittels oder Lösungsmittelgemisches auf. Die jeweilige Zielverbindung kann also nach der Isolierung ohne weitere Aufreinigung verwendet und/oder gelagert werden. Die reproduzierbare Ausbeute ist beispielsweise für [W(N*t*Bu)₂(NMe₂)₂] - auch im Falle einer Hochskalierung in Richtung industriellem Maßstab - zufriedenstellend.

Insgesamt werden mit dem beanspruchten Verfahren die Nachteile des Standes der Technik überwunden. Dabei fallen insbesondere keine schwierig abtrennbaren Salzfrachten an, wie z. B. LiCI in Diethylether. Auf potentiell koordinierende Solventien, wie Pyridin und Diethylether, wird gänzlich verzichtet. Das Verfahren zeichnet sich durch eine besonders einfache und kostengünstige Verfahrensführung aus, weil es sich um eine einfache zweistufige Synthese handelt. Zudem sind wenige und präparativ einfach zu bewerkstelligende Prozessschritte notwendig. Dabei werden nur kommerziell gut verfügbare, synthetisch relativ einfach zugängliche und relativ kostengünstige Edukte eingesetzt. Es entstehen nur definierbare, einfach und quantitativ abtrennbare Nebenprodukte. Insbesondere kommt es nicht zur Bildung nicht abtrennbarer Lithium-Wolframat-Komplexsalze. Daher werden Verbindungen des Typs [W(N*t*Bu)₂(NR^{A}R^{B})₂] (I), wie z. B. Bis(*tert*-butylimido)bis(dimethylamido)wolfram, reproduzierbar bereits ohne weitere destillative und/oder sublimative Aufreinigung in hoher Reinheit erhalten. Es kann aber beispielsweise eine Umkondensation und/oder eine Destillation und/oder eine sublimative Aufreinigung vorgesehen sein. Die mit dem beanspruchten Verfahren darstellbaren Bis(*tert*-butylimido)bis(dialkylamido)wolfram-Verbindungen erfüllen die Reinheitsanforderungen an Präkursoren zur Herstellung qualitativ hochwertiger Substrate, welche Wolfram-Schichten oder Wolfram enthaltende Schichten aufweisen. Insbesondere weisen die mit dem beanspruchten Verfahren herstellbaren Verbindungen des Typs [W(N*t*Bu)₂(NR^{A}R^{B})₂] (I) naturgemäß, nämlich aufgrund des Verzichts auf Edukte, wie z. B. Lithiumdimethylamid, keine Lithiumverunreinigungen auf. Darüber hinaus kann das Verfahren auch im industriellen Maßstab durchgeführt werden, wobei vergleichbare Ausbeuten und Reinheiten der Zielverbindungen erreicht werden. Das beanspruchte Verfahren ist vergleichsweise zeit-, energie- und kostensparend. Insgesamt ist es als vergleichsweise (atom)ökonomischer und ökologischer einzustufen.

In einer Ausführungsform des beanspruchten Verfahrens zur Herstellung von Bis(*tert-*butylimido)bis(dialkylamido)wolfram-Verbindungen gemäß der allgemeinen Formel [W(N*t*Bu)₂(NR^{A}R^{B})₂] (I) sind R^{A} und R^{B} unabhängig voneinander ausgewählt aus der Gruppe bestehend aus Me, Et, *n*Pr, *i*Pr, *n*Bu, *t*Bu, *s*Bu, *i*Bu, CH₂*s*Bu, CH₂*i*Bu, CH(Me)(*i*Pr), CH(Me)(nPr), CH(Et)₂, C(Me)₂(Et), C₆H₁₁, CH₂C₆H₅ und C₆H₅.

In einer weiteren Ausführungsform des beanspruchten Verfahrens die Zurverfügungstellung von [W(N*t*Bu)₂(NH*t*Bu)₂] in Schritt a) eine Umsetzung von WCl₆ mit *t*BuNH₂ in Gegenwart einer Hilfsbase in einem aprotischen Lösungsmittel M_{A}. Dabei ist ein molares Verhältnis WCl₆ : *t*BuNH₂ ≤ 1 : 4.

Als Edukt wird das kostengünstige, kommerziell erhältliche WCl₆ eingesetzt. Davon ausgehend erfolgt durch Umsetzung mit wenigstens vier Moläquivalenten *t*BuNH₂ in dem aprotischen Lösungsmittel M_{A} eine Herstellung des Zwischenprodukts [W(N*t*Bu)₂(NH*t*Bu)₂]. Der dabei als einziges Nebenprodukt anfallende Chlorwasserstoff wird mittels einer im Reaktionsgemisch enthaltenen Hilfsbase abgefangen.

Als Hilfsbase kann grundsätzlich jede Verbindung eingesetzt werden, welche unter den jeweils gewählten Reaktionsbedingungen in der Lage ist, den während der jeweiligen Reaktion entstehenden Chlorwasserstoff quantitativ abzufangen. Die Hilfsbase muss sich insbesondere dadurch auszeichnen, dass sie den pH-Wert des Reaktionsgemisches und den Wassergehalt des Reaktionsmediums nicht beeinflusst und gegenüber den Edukten WCl₆ und *t*BuNH₂ sowie dem gewünschten Zwischenprodukt [W(N*t*Bu)₂(NH*t*Bu)₂] nicht als Reaktand fungiert. Zudem muss ein gegebenenfalls eingesetzter Überschuss der Hilfsbase einfach quantitativ aus dem Reaktionsgemisch entfernbar sein und das durch die Reaktion der Hilfsbase mit dem Chlorwasserstoff anfallende Produkt muss ebenfalls einfach quantitativ abtrennbar sein. Ein molares Verhältnis WCl₆ : Hilfsbase wird so gewählt, dass wenigstens sechs Moläquivalente Chlorwasserstoff abgefangen werden können.

Im einfachsten Fall ist *t*BuNH₂ sowohl Reaktand beziehungsweise Edukt als auch Hilfsbase. Dann reagiert der während der Reaktion entstehende Chlorwasserstoff mit dem im Überschuss eingesetzten Amin *t*BuNH₂ zu *t*BuNH₃Cl. Überschuss bedeutet in diesem Zusammenhang, dass pro Moläquivalent WCl₆ wenigstens zehn - anstelle der formal für die Darstellung von [W(N*t*Bu)₂(NH*t*Bu)₂] erforderlichen vier - Äquivalente *t*BuNH₂ eingesetzt werden. Das molare Verhältnis WCl₆ : *t*BuNH₂ ist in diesem einfachsten Fall also ≤ 1 : 10. Gegebenenfalls nicht umgesetztes *t*BuNH₂ kann einfach durch Anlegen eines Unterdrucks an einen Innenraum des jeweiligen Reaktionsbehältnisses entfernt werden. Alternativ kann vorgesehen sein, dass die Hilfsbase das Amin *t*BuNH₂ lediglich umfasst, d. h. ein Teil der Hilfsbase *t*BuNH₂ durch eine andere Hilfsbase ersetzt ist. Dann ist das in dem Reaktionsgemisch insgesamt vorgesehene molare Verhältnis WCl₆ : *t*BuNH₂ < 1 : 4 und > 1 : 10, d. h. < 0,25 und > 0,10.

Der Begriff Reaktionsbehältnis ist im Zusammenhang mit der vorliegenden Erfindung nicht auf ein Volumen, eine Materialbeschaffenheit, eine Ausstattung oder eine Form beschränkt.

Nach Durchführung der Umsetzung von WCl₆ mit *t*BuNH₂ in Gegenwart einer Hilfsbase liegen ausschließlich das gewünschte Zwischenprodukt [W(N*t*Bu)₂(NH*t*Bu)₂] sowie definierte, vergleichsweise einfach abtrennbare Nebenprodukte, in der Regel ein Ammoniumsalz, beispielsweise *t*BuNH₃Cl, und gegebenenfalls nicht umgesetztes, d. h. im Überschuss eingesetztes, *t*BuNH₂ vor. Im Reaktionsgemisch noch vorhandesnes *t*BuNH₂ kann einfach durch Anlegen eines Unterdrucks an einen Innenraum des jeweiligen Reaktionsbehältnisses entfernt werden. Die relativ einfache Abtrennbarkeit des ausgefallenen Ammoniumsalzes, beispielsweise *t*BuNH₃Cl, lässt sich auch mit der vorteilhaften Wahl des aprotischen Lösungsmittels M_{A} begründen.

Eine Ausführungsform des Verfahrens sieht vor, dass aprotische Lösungsmittel M_{A} ausgewählt ist aus der Gruppe bestehend aus Kohlenwasserstoffen, Benzol und Benzolderivaten. Das erste Lösungsmittel ist beispielsweise ausgewählt aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol, Xylol sowie deren Isomeren. Bevorzugt handelt es sich bei dem aprotischen Lösungsmittel M_{A} um *n*-Hexan, *i*-Hexan oder *n*-Heptan oder ein Gemisch, umfassend wenigstens eines dieser Lösungsmittel. Die vorgenannten Lösungsmittel, insbesondere Benzol und Toluol, können vorteilhafterweise ohne Verluste vollständig rezyklisiert werden. Dies wirkt sich positiv auf die Ökobilanz des Verfahrens aus.

In einer weiteren Variante des beanspruchten Verfahrens umfasst in Schritt a) die Umsetzung von WCl₆ mit *t*BuNH₂ in Gegenwart der Hilfsbase, in dem aprotischen Lösungsmittel M_{A} folgende Schritte:
i) Bereitstellen einer Lösung von *t*BuNH₂ in dem aprotischen Lösungsmittel M_{A},
ii) Hinzufügen der Hilfsbase,
iii) Hinzufügen von WCl₆,
wobei während des Hinzufügens und/oder nach dem Hinzufügen von WCl₆ eine Reaktion von WCl₆ mit *t*BuNH₂ erfolgt.

Das aprotische Lösungsmittel M_{A} kann auch ein Lösungsmittelgemisch sein.

Bevorzugt ist die Hilfsbase *t*BuNH₂, wobei ein molares Verhältnis WCl₆ : Hilfsbase *t*BuNH₂ ≤ 1 : 6 ist. Zusammen mit dem als Reaktand für die Darstellung von [W(N*t*Bu)₂(NR^{A}R^{B})₂] (I) benötigten *tert*-Butylamin liegt somit ein molares Verhältnis WCl₆ : *t*BuNH₂ ≤ 1 : 10 vor. Fungiert *t*BuNH₂ sowohl als Edukt als auch als Hilfsbase, ist die Verfahrensführung besonders einfach. Denn zum einen wird die Anzahl der erforderlichen Chemikalien reduziert. Zum anderen erfolgen Schritt i), nämlich das Bereitstellen einer Lösung von *t*BuNH₂ in dem aprotischen Lösungsmittel M_{A} und Schritt ii), nämlich das Hinzufügen der Hilfsbase, in einem einzigen Schritt.

Wird in einer anderen Ausführungsform des beanspruchten Verfahrens eine andere Hilfsbase als das Amin *t*BuNH₂ eingesetzt, kann vorgesehen sein, dass das Hinzufügen dieser Hilfsbase in dem separaten Schritt ii) erfolgt. Die Hilfsbase wird in Substanz, d. h. in der Regel als Feststoff oder Flüssigkeit, oder als Suspension oder Lösung in einem Solvens S_{H} hinzugefügt. Dabei ist das Solvens S_{H} mit dem aprotischen Lösungsmittel M_{A} identisch oder mischbar.

Im Zusammenhang mit der vorliegenden Erfindung werden zwei Lösungsmittel als mischbar bezeichnet, wenn sie zumindest während der jeweiligen Umsetzung mischbar sind, also nicht als zwei Phasen vorliegen.

In einer Ausführungsform des beanspruchten Verfahrens ist vorgesehen, dass in Schritt iii) WCl₆ in einem Solvens Sw suspendiert oder als Feststoff hinzugefügt wird. Das Solvens S_{W} ist mit dem aprotischen Lösungsmittel M_{A} identisch oder mischbar. Das Hinzufügen von WCl₆ als Suspension in dem Solvens S_{W} kann - in Abhängigkeit von den übrigen Reaktionsparametern - zur besseren Kontrolle des Reaktionsverlaufs bzw. der Exothermie vorteilhaft sein. Dann erfolgt das Hinzufügen beispielsweise unter Verwendung einer Dosiervorrichtung, insbesondere durch Zutropfen oder Zuspritzen. Wird WCl₆ als Feststoff hinzugefügt, ist für die Zugabe beispielsweise ein Trichter oder eine trichterähnliche Vorrichtung vorgesehen. Alternativ oder ergänzend kann - unabhängig von der Zugabeform von WCl₆ - in einer Zuleitung des jeweiligen Reaktionsbehältnisses ein Absperrventil und/oder ein Absperrhahn vorgesehen sein.

In einer noch anderen Ausführungsform des beanspruchten Verfahrens wird in Schritt i) WCl₆ als Suspension in dem aprotischen Lösungsmittel M_{A} bereitgestellt beziehungsweise vorgelegt. Ist *t*BuNH₂ als Hilfsbase vorgesehen, erfolgen Schritt ii) und Schritt iii) in einem einzigen Schritt. Dabei erfolgt das Hinzufügen von *t*BuNH₂ als Lösung in einem Solvens S_{R} oder als Flüssigkeit, d. h. ohne Zugabe eines Lösungsmittels, jeweils beispielsweise durch Zutropfen oder Zuspritzen. Das Solvens S_{R} mit dem aprotischen Lösungsmittel M_{A} identisch oder mischbar. Ist eine andere Hilfsbase als *t*BuNH₂ vorgesehen, erfolgt das Hinzufügen dieser Hilfsbase in dem separaten Schritt ii). Die Hilfsbase wird in Substanz, d. h. in der Regel als Feststoff oder Flüssigkeit, oder als Suspension oder Lösung in einem Solvens S_{B} hinzugefügt. Die Zugabe des Edukts *t*BuNH₂ erfolgt dann in Schritt iii) als Lösung in einem Solvens S_{P} oder als Flüssigkeit, d. h. ohne Zugabe eines Lösungsmittels, jeweils beispielsweise durch Zutropfen oder Zuspritzen. Dabei sind die Solventien S_{B} und Sp jeweils mit dem aprotischen Lösungsmittel M_{A} identisch oder mischbar.

Je nach Wahl des aprotischen Lösungsmittels oder Lösungsmittelgemisches M_{A} sowie der übrigen Reaktionsbedingungen, wie z. B. Zugabeform von WCl₆, d. h. als Substanz oder als Suspension, Geschwindigkeit des Hinzufügens von WCl₆, Rührgeschwindigkeit, Innentemperatur des jeweiligen Reaktionsbehältnisses, erfolgt die Reaktion von WCl₆ mit *t*BuNH₂ in Gegenwart der Hilfsbase bereits während des Hinzufügens und/oder nach dem Hinzufügen von WCl₆.

In einer anderen Variante des beanspruchten Verfahrens wird die Umsetzung von WCl₆ mit *t*BuNH₂ in Gegenwart der Hilfsbase, insbesondere *t*BuNH₂, in dem aprotischen Lösungsmittel M_{A} bei einer Temperatur T_{U} durchgeführt, wobei die Temperatur T_{U} zwischen -30 °C und 100 °C beträgt.

Mit Temperatur T_{U} ist die Innentemperatur T_{U} des jeweiligen Reaktionsbehältnisses gemeint.

Aufgrund der Exothermie der Reaktion kann es von Vorteil sein, die Geschwindigkeit des Hinzufügens von WCl₆ und/oder die Temperatur T_{U} vergleichsweise niedrig zu wählen. Alternativ oder ergänzend kann vorgesehen sein, dass eine Suspension von WCl₆ in einem aprotischen Lösungsmittel oder Lösungsmittelgemisch hinzugefügt wird. Die jeweilige Vorgehensweise ist unter Berücksichtigung der übrigen Reaktionsparameter, wie z. B. der *t*BuNH₂-Konzentration (Edukt) und des Lösungsmittels oder Lösungsmittelgemisches, zu wählen.

In einer weiteren Ausführungsform des Verfahrens beträgt die Temperatur T_{U} des während der Umsetzung von WCl₆ mit *t*BuNH₂ in Gegenwart der Hilfsbase, insbesondere *t*BuNH₂, zwischen -20 °C und 80 °C. In einer noch anderen Ausführungsform des Verfahrens beträgt die Temperatur T_{U} während der Umsetzung von WCl₆ mit *t*BuNH₂ in Gegenwart der Hilfsbase, insbesondere *t*BuNH₂, zwischen -10 °C und 50 °C.

Eine Innentemperatur des jeweiligen Reaktionsbehältnisses kann mithilfe eines Temperatursensors oder mehrerer Temperatursensoren für einen Bereich oder mehrere Bereiche des Reaktionsbehältnisses ermittelt werden. Dabei ist zumindest ein Temperatursensor für die Ermittlung der Temperatur T_{U} vorgesehen, welche in der Regel einer Durchschnittstemperatur T_{D1} des Reaktionsgemisches entspricht.

In einer weiteren Variante des Verfahrens wird die Temperatur T_{U} unter Verwendung eines Wärmeträgers W_{U} geregelt und/oder gesteuert. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{U} können Abweichungen der Temperatur T_{U} von einem für die Umsetzung von WCl₆ mit *t*BuNH₂ in Gegenwart der Hilfsbase, insbesondere *t*BuNH₂, festgelegten Sollwert T_{S1} weitestgehend abgefangen bzw. kompensiert werden. Die Realisierung einer konstanten Temperatur T_{U} ist aufgrund der üblichen Geräteabweichungen kaum möglich. Durch die Verwendung des Wärmeträgers W_{U} kann die Umsetzung von WCl₆ mit *t*BuNH₂ in Gegenwart der Hilfsbase, insbesondere *t*BuNH₂, aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm zu erstellen. Dabei kann zum Beispiel während einer ersten Phase des Hinzufügens von WCl₆ eine niedrigere Temperatur bzw. ein niedrigerer Temperaturbereich gewählt werden als in einer zweiten Phase des Hinzufügens von WCl₆. Es können auch mehr als zwei Phasen des Hinzufügens und damit mehr als zwei vorgewählte Temperaturen bzw. Temperaturbereiche vorgesehen sein. Je nach Wahl der übrigen Reaktionsbedingungen, wie z. B. der *t*BuNH₂-Konzentration (Edukt) und des Lösungsmittels oder Lösungsmittelgemisches, kann es während des Hinzufügens und/oder nach dem Hinzufügen von WCl₆ günstig sein, eine Erhöhung der Temperatur T_{U} unter Verwendung des Wärmeträgers W_{U} durchzuführen. Dadurch kann gegebenenfalls sichergestellt werden, dass die Umsetzung von WCl₆ mit *t*BuNH₂ in Gegenwart der Hilfsbase, insbesondere *t*BuNH₂, quantitativ erfolgt.

Umfasst die Zurverfügungstellung von [W(N*t*Bu)₂(NH*t*Bu)₂] in Schritt a) eine Umsetzung von WCl₆ mit *t*BuNH₂ in Gegenwart einer Hilfsbase in einem aprotischen Lösungsmittel M_{A}, sieht eine weitere Variante des beanspruchten Verfahrens vor, dass vor der Umsetzung von [W(N*t*Bu)₂(NH*t*Bu)₂] in Schritt b) ein Filtrationsschritt durchgeführt wird. Der Filtrationsschritt oder ein Dekantieren erfolgen insbesondere zur Abtrennung des während der Umsetzung von WCl₆ mit *t*BuNH₂ in Gegenwart einer Hilfsbase, insbesondere *t*BuNH₂, angefallenen Ammoniumsalzes, insbesondere *t*BuNH₃Cl. Werden zum Beispiel *n*-Hexan, *i*-Hexan und/oder *n*-Heptan als Solvens eingesetzt, fällt das Ammoniumsalz, beispielsweise *t*BuNH₃Cl, quantitativ aus, während das Zwischenprodukt [W(N*t*Bu)₂(NH*t*Bu)₂] in Lösung bleibt. Es können im Rahmen der Isolierung des Zwischenprodukts [W(N*t*Bu)₂(NH*t*Bu)₂] auch mehrere Filtrationsschritte vorgesehen sein, gegebenenfalls auch eine oder mehrere Filtrationen über einem Reinigungsmedium, wie z. B. Aktivkohle oder Silica, z. B. Celite®. Der Filterkuchen, welcher die Ammoniumsalz-Fracht umfasst, kann mit einer geringen Menge eines leicht flüchtigen Lösungsmittels gewaschen werden, um eventuell in der Ammoniumsalz-Fracht-Fracht enthaltenes Produkt zu extrahieren. Eine Verunreinigung des jeweils in Schritt b) darzustellenden Bis(*tert-*butylimido)bis(dialkylamido)wolfram-Komplexes durch die anfallende Ammoniumsalz-Fracht, beispielsweise *t*BuNH₃Cl, wird somit vorteilhafterweise vermieden.

Eine andere Variante des Verfahrens sieht vor, dass vor der Umsetzung von [W(N*t*Bu)₂(NH*t*Bu)₂] in Schritt b) eine Isolierung von [W(N*t*Bu)₂(NH*t*Bu)₂] durchgeführt wird.

Die Isolierung kann ein Entfernen aller flüchtigen Bestandteile, d. h. des Lösungsmittels oder Lösungsmittelgemisches M_{A} und von gegebenenfalls nicht umgesetztem, d. h. im Überschuss eingesetzten, *t*BuNH₂, umfassen. In einer weiteren Ausführungsform des beanspruchten Verfahrens umfasst die Isolierung von [W(N*t*Bu)₂(NH*t*Bu)₂] ein Anlegen eines Unterdrucks p_{W} an einen Innenraum des Reaktionsgefäßes. Der Unterdruck p_{W} beträgt - in Abhängigkeit von den übrigen Reaktionsbedingungen, insbesondere je nach Lösungsmittel - beispielsweise 10⁻³ bis 10¹ mbar. Dadurch ist es beispielsweise möglich, das Lösungsmittel oder Lösungsmittelgemisch aus Schritt a) vollständig oder nahezu vollständig abzutrennen und zu rezyklisieren. Dies ist aus ökonomischer und ökologischer Sicht besonders vorteilhaft.

Die Isolierung kann weitere Verfahrensschritte umfassen, wie z. B. die Reduzierung des Volumens der Mutterlauge, d. h. Einengen, z. B. mittels "bulb-to-bulb", die Zugabe eines Lösungsmittels und/oder einen Lösungsmittelaustausch, um eine Fällung des Produktes aus der Mutterlauge zu erzielen und/oder Verunreinigungen und/oder Edukte zu entfernen, Waschen und Trocknen des Produktes. Des Weiteren kann vorgesehen sein, dass die Isolierung eine Destillation und/oder eine Sublimation und/oder eine Kristallisation und/oder eine Umkristallisation umfasst.

Für eine spätere Umsetzung von [W(N*t*Bu)₂(NH*t*Bu)₂], insbesondere gemäß Schritt b) des hier beanspruchten Verfahrens, ist in der Regel keine Aufreinigung erforderlich. Ist dennoch eine Aufreinigung erwünscht und/oder erforderlich, kann die Isolierung eine Destillation und/oder eine Sublimation und/oder eine Kristallisation und/oder eine Umkristallisation umfassen. Die Sublimation von [W(N*t*Bu)₂(NH*t*Bu)₂] ist vergleichsweise einfach und schnell durchführbar. Zudem wird durch die Sublimation von [W(N*t*Bu)₂(NH*t*Bu)₂] - im Unterschied zu der in der Literatur beschriebenen Umkristallisation aus Toluol - vorteilhafterweise eine deutliche Steigerung der Ausbeute erzielt (vgl. hierzu Ausführungsbeispiel 1).

Dies isolierte und gegebenenfalls aufgereinigte Verbindung [W(N*t*Bu)₂(NH*t*Bu)₂] kann auch für eine spätere Verwendung gelagert werden.

In einer weiteren Ausführungsform des beanspruchten Verfahrens ist in Schritt b) das molare Verhältnis [W(N*t*Bu)₂(NH*t*Bu)₂] : HNR^{A}R^{B} ≤ 1 : 4. Bereits bei einem molaren Verhältnis von genau 1 : 4, d. h. 0,25, wird ein vergleichsweise großer Überschuss des Amins eingesetzt HNR^{A}R^{B}, nämlich doppelt so viele Moläquivalente dieses Edukts als formal benötigt werden. Die im Einzelfall zu wählende Höhe des Überschusses an HNR^{A}R^{B} hängt insbesondere von der Reaktivität des jeweils in Schritt b) als Edukt eingesetzten sekundären Amins selbst ab, insbesondere unter Berücksichtigung der ansonsten gewählten Reaktionsparamater, wie z. B. des Lösungsmittels oder Lösungsmittelgemisches.

Gemäß einer weiteren Ausführungsform umfasst das Lösungsmittel M_{U} ein aprotisches Lösungsmittel. Eine andere Ausführungsform des beanspruchten Verfahrens sieht vor, dass das Lösungsmittel M_{U} mit dem aprotischen Lösungsmittel M_{A} mischbar oder identisch ist. In diesem Zusammenhang hat der Begriff "identisch" zwei unterschiedliche Bedeutungen, wie den Ausführungen des nachfolgenden Absatzes entnommen werden kann.

Nach Beendigung des Schrittes a) kann die vorliegende Reaktionsmischung beispielsweise einem Filtrationsschritt unterzogen werden, um das als Nebenprodukt angefallene Ammoniumsalz, beispielsweise *t*BuNH₃Cl, abzutrennen. Dazu kann das Filtrat, welches das Rohprodukt [W(N*t*Bu)₂(NH*t*Bu)₂] aus Schritt a) enthält, beispielsweise in einem anderen Behälter aufgefangen und nach Abtrennung des Ammoniumsalzes, z. B. *t*BuNH₃Cl, wieder in das jeweilige Reaktionsbehältnis überführt werden. Dies kann beispielsweise mittels eines Pumpvorgangs erfolgen. In diesem Fall umfasst das Lösungsmittel M_{U} das aprotische Lösungsmittel M_{A} oder ist - falls kein weiteres Lösungsmittel hinzugefügt wird - mit ihm identisch. Es kann weiterhin vorgesehen sein, dass das aprotische Lösungsmittel oder Lösungsmittelgemisch M_{A} durch Anlegen eines Unterdrucks an einen Innenraum des jeweiligen Reaktionsbehältnisses entfernt und nicht wieder zurückgeführt wird. Dies ist beispielsweise erforderlich, wenn für die Umsetzung gemäß Schritt b) ein Lösungsmittel M_{U} bevorzugt wird, welches vom aprotischen Lösungsmittel M_{A} verschieden ist. Für den Fall, dass das Rohprodukt [W(N*t*Bu)₂(NH*t*Bu)₂] nach dem Entfernen des aprotischen Lösungsmittels M_{A} gegebenenfalls noch Reste dieses Lösungsmittels aufweist, ist es für die weitere Umsetzung gemäß Schritt b) vorteilhaft, wenn das Lösungsmittel M_{U} mit dem Lösungsmittel M_{A} mischbar ist. Der Begriff "mischbar" ist bereits weiter oben definiert worden. Wurde das Rohprodukt aus Schritt a) zwischenzeitlich isoliert, gegebenenfalls aufgereinigt, und gelagert, kann es - je nach Wahl der übrigen Reaktionsbedingungen - für die Umsetzung gemäß Schritt b) auch in einem Lösungsmittel M_{U} gelöst werden, welches mit dem aprotischen Lösungsmittel M_{A} identisch ist. Wurde beispielsweise als aprotisches Lösungsmittel M_{A} *n*-Hexan verwendet, kann als Lösungsmittel M_{U} wiederum *n*-Hexan eingesetzt werden, wobei Letzteres gegebenenfalls aus dem Verfahren rezyklisiert sein kann, aber nicht muss.

In einer Variante des beanspruchten Verfahrens ist das aprotische Lösungsmittel, welches das Lösungsmittel M_{U} umfasst, ausgewählt aus der Gruppe bestehend aus Kohlenwasserstoffen, Benzol und Benzolderivaten. Beispielsweise ist das aprotische Lösungsmittel, welches das Lösungsmittel M_{U} umfasst, ausgewählt aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol, Xylol sowie deren Isomeren. Bevorzugt sind *n*-Hexan, *i*-Hexan und *n*-Heptan sowie Lösungsmittelgemische, umfassend wenigstens eines dieser Lösungsmittel.

Eine noch andere Ausführungsform des beanspruchten Verfahrens sieht vor, dass das Lösungsmittel M_{U} ein reaktives Lösungsmittel umfasst. Im Zusammenhang mit der vorliegenden Erfindung ist mit dem Begriff "reaktives Lösungsmittel" ein Lösungsmittel gemeint, welches chemisch nicht inert ist. Das reaktive Lösungsmittel kann unter den jeweiligen Reaktionsbedingungen mit einem potentiellen Reaktionspartner reagieren, z. B. mit einem Edukt und/oder einem Produkt. Art und Ausmaß der Reaktivität des reaktiven Lösungsmittels sind abhängig von der im jeweiligen Reaktionsgemisch vorliegenden Konzentration des reaktiven Lösungsmittels, den potentiellen Reaktionspartnern, der im jeweiligen Reaktionsgemisch vorliegenden Konzentration und Reaktivität der potentiellen Reaktionspartner und den jeweils gewählten übrigen Reaktionsbedingungen.

In einer weiteren Variante des beanspruchten Verfahrens umfasst das reaktive Lösungsmittel das Amin HNR^{A}R^{B}. In einer anderen Ausführungsform des beanspruchten Verfahrens ist vorgesehen, dass das Lösungsmittel M_{U} ein Lösungsmittelgemisch darstellt, umfassend das Amin HNR^{A}R^{B} als reaktives Lösungsmittel und wenigstens ein aprotisches Lösungsmittel. Dabei ist das wenigstens eine aprotische Lösungsmittel ausgewählt aus der Gruppe bestehend aus *n*-Pentan, *n*-Hexan, *n*-Heptan, *n*-Octan, *n*-Nonan, *n*-Decan, *n-*Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol, Xylol sowie deren Isomeren. Entscheidend für die Auswahl des aprotischen Lösungsmittels ist, dass das Amin HNR^{A}R^{B} und das aprotische Lösungsmittel oder Lösungsmittelgemisch mischbar sind, d. h. zumindest während der Umsetzung gemäß Schritt b) mischbar sind, also nicht als zwei Phasen vorliegen.

Eine weitere Ausführungsform des beanspruchten Verfahrens sieht vor, dass das molare Verhältnis [W(N*t*Bu)₂(NH*t*Bu)₂] : HNR^{A}R^{B} zwischen 1 : 200 und 1 : 10.000 beträgt.

In einer noch anderen Ausführungsform ist das Amin HNR^{A}R^{B} selbst das reaktive Lösungsmittel. Dann wird die Umsetzung von [W(N*t*Bu)₂(NH*t*Bu)₂] mit HNR^{A}R^{B} beispielsweise in dem Amin HNR^{A}R^{B} als Edukt beziehungsweise Reaktand und einzigem Lösungsmittel durchgeführt. Dabei ist vorgesehen, dass der als Lösungsmittel verwendete Anteil des Amin HNR^{A}R^{B} rezyklisiert wird.

In einer anderen Variante des beanspruchten Verfahrens wird Schritt b) bei einer Temperatur T_{R} und/oder einem Druck p_{R} des jeweiligen Reaktionsbehältnisses durchgeführt wird.

Mit Temperatur T_{R} ist die Innentemperatur T_{R} des jeweiligen Reaktionsbehältnisses gemeint, mit Druck p_{R} der Innendruck p_{R} des jeweiligen Reaktionsbehältnisses.

Bei der Temperatur T_{R} und/oder dem Druck p_{R} liegt wenigstens ein Anteil eines Stoffmengenanteils des Amins NHR^{A}R^{B} in flüssiger oder gelöster Form vor. Insbesondere ist vorgesehen, dass der wenigstens eine Anteil des insgesamt eingesetzten Stoffmengenanteils des Amins NHR^{A}R^{B} dem als Edukt vorgesehenen Stoffmengenanteil des Amins NHR^{A}R^{B} entspricht, damit die Umsetzung in Schritt b) vollständig ablaufen kann. Die Temperatur T_{R} und der Druck p_{R} sind jeweils in Abhängigkeit vom gewählten Amin NHR^{A}R^{B} sowie den übrigen Reaktionsbedingungen, z. B. Wahl des Lösungsmittels, zu wählen. Die hier beschriebene Ausführungsform des beanspruchten Verfahrens ist beispielsweise dann vorgesehen, wenn das eingesetzte Amin NHR^{A}R^{B} einen vergleichsweise niedrigen Siedepunkt aufweist, wie z. B. Dimethylamin. Dann ist es für die Durchführung von Schritt b) vorteilhaft, das jeweilige Amin durch eine Anpassung der Temperatur T_{R} und der Drucks p_{R}, insbesondere eine Erniedrigung der Temperatur T_{R} oder eine Erhöhung des Druck p_{R}, in den flüssigen Aggregatzustand zu überführen und/oder für eine gewisse Zeit in diesem Aggregatzustand zu halten. Weiterhin ist die hier beschriebene Variante des beanspruchten Verfahrens vorteilhafterweise dann vorgesehen, wenn das sowohl als Edukt als auch als reaktives Lösungsmittel eingesetzte Amin NHR^{A}R^{B} ein Feststoff ist oder unter den ansonsten gewählten Reaktionsbedingungen als Feststoff vorliegt. Zudem ist diese Variante des beanspruchten Verfahrens vorteilhaft, wenn das ausschließlich als Edukt eingesetzte Amin NHR^{A}R^{B} unter den ansonsten gewählten Reaktionsbedingungen nicht mit dem, insbesondere aprotischen, Lösungsmittel M_{U} mischbar beziehungsweise darin löslich ist.

In einer weiteren Ausführungsform des beanspruchten Verfahrens umfasst in Schritt b) die Umsetzung von [W(N*t*Bu)₂(NH*t*Bu)₂] aus Schritt a) mit dem Amin HNR^{A}R^{B} in dem Lösungsmittel M_{U} folgende Schritte:
i) Bereitstellen von [W(N*t*Bu)₂(NH*t*Bu)₂]
   - als Feststoff
      oder
   - als Lösung oder Suspension in dem Lösungsmittel M_{U},
   und
ii) Hinzufügen des Amins HNR^{A}R^{B},
wobei während des Hinzufügens und/oder nach dem Hinzufügen des Amins HNR^{A}R^{B} eine Reaktion von [W(N*t*Bu)₂(NH*t*Bu)₂] mit dem Amin HNR^{A}R^{B} erfolgt.

Das Lösungsmittel M_{U} kann auch ein Lösungsmittelgemisch sein, d. h. zwei oder mehr Lösungsmittel umfassen.

In einer Ausführungsform des Verfahrens wird in Schritt b) ii) das Amin HNR^{A}R^{B} zu der in Schritt b) i) bereitgestellten Verbindung [W(N*t*Bu)₂(NH*t*Bu)₂]
- als Gas oder Flüssigkeit
   oder
- in dem Lösungsmittel M_{U} gelöst
hinzugefügt.

Eine Variante des Verfahrens sieht vor, dass in Schritt b) ii) das Hinzufügen des Amins HNR^{A}R^{B} unter Verwendung einer Dosiervorrichtung erfolgt. Das Hinzufügen kann beispielsweise durch Zutropfen oder Zuspritzen erfolgen. Alternativ oder ergänzend kann in einer Zuleitung des jeweiligen Reaktionsbehältnisses ein Absperrventil und/oder ein Absperrhahn vorgesehen sein. Das Hinzufügen des Amins HNR^{A}R^{B} als Lösung in dem, insbesondere aprotischen, Lösungsmittel M_{U} kann - in Abhängigkeit von den übrigen Reaktionsparametern - zur besseren Kontrolle des Reaktionsverlaufs bzw. der Exothermie vorteilhaft sein.

Eine andere Variante des Verfahrens sieht vor, dass eine Temperatur T_{C} während des Hinzufügens und/oder nach dem Hinzufügen des Amins HNR^{A}R^{B} zwischen -60 °C und 50 °C beträgt.

Mit Temperatur T_{C} ist die Innentemperatur T_{C} des jeweiligen Reaktionsbehältnisses gemeint.

In einer weiteren Variante des Verfahrens beträgt die Temperatur T_{C} während des Hinzufügens und/oder nach dem Hinzufügen des Amins HNR^{A}R^{B} zwischen -40 °C und 30 °C. In einer noch anderen Ausführungsform des Verfahrens beträgt die Temperatur T_{C} während des Hinzufügens und/oder nach dem Hinzufügen des Amins HNR^{A}R^{B} zwischen -30 °C und 20 °C. Dabei ist zumindest ein Temperatursensor für die Ermittlung der Temperatur T_{C} vorgesehen, welche in der Regel einer Durchschnittstemperatur T_{D2} des Reaktionsgemisches entspricht. Der Temperatursensor kann identisch mit demjenigen für die Ermittlung der Temperatur T_{U} sein.

In einer weiteren Ausführungsform des Verfahrens wird die Temperatur T_{C} unter Verwendung eines Wärmeträgers W_{C} geregelt und/oder gesteuert. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{C} können Abweichungen der Temperatur T_{C} von einem für die Zeit während des Hinzufügens und/oder nach dem Hinzufügen des Amins HNR^{A}R^{B} festgelegten Sollwert T_{S2} weitestgehend abgefangen bzw. kompensiert werden. Die Realisierung einer konstanten Temperatur T_{C} ist aufgrund der üblichen Geräteabweichungen kaum möglich. Durch die Verwendung des Wärmeträgers W_{C} kann die Umsetzung des in Schritt a) zur Verfügung gestellten [W(N*t*Bu)₂(NH*t*Bu)₂] mit dem Amin HNR^{A}R^{B} aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm beziehungsweise ein Temperaturprofil zu erstellen. Dabei kann zum Beispiel während einer ersten Phase des Hinzufügens des Amins HNR^{A}R^{B} eine niedrigere Temperatur bzw. ein niedrigerer Temperaturbereich gewählt werden als in einer zweiten Phase des Hinzufügens des Amins HNR^{A}R^{B}. Es können auch mehr als zwei Phasen des Hinzufügens und damit mehr als zwei vorgewählte Temperaturen bzw. Temperaturbereiche vorgesehen sein. Nach dem Hinzufügen können ebenfalls eine oder mehrere Phasen zur schrittweisen Erhöhung der Temperatur T_{C} vorgesehen sein. Insgesamt wird durch ein solches Temperaturprogramm bzw. Temperaturprofil eine bessere Kontrolle der Exothermie bzw. des Reaktionsverlaufs erreicht. Insbesondere können auf diese Weise unspezifische Nebenreaktionen und/oder die Zersetzung des jeweiligen Produktes [W(N*t*Bu)₂(NR^{A}R^{B})₂] (I) verhindert oder zumindest reduziert werden.

In einer noch anderen Variante des beanspruchten Verfahrens erfolgt nach Schritt b) eine Isolierung von [W(N*t*Bu)₂(NR^{A}R^{B})₂] (I).

Soll die jeweils in Lösung befindliche Bis(*tert*-butylimido)bis(dialkylamido)wolfram-Verbindung gemäß der allgemeinen Formel [W(N*t*Bu)₂(NR^{A}R^{B})₂] (I) nicht unmittelbar weiter umgesetzt, sondern isoliert und dann gelagert und/oder weiterverwendet werden, kann ihre Isolierung einen oder mehrere Schritte umfassen.

In einer Variante des Verfahrens umfasst die Isolierung von [W(N*t*Bu)₂(NR^{A}R^{B})₂] (I) ein Anlegen eines Unterdrucks p_{X} an einen Innenraum des jeweiligen Reaktionsgefäßes. Der Unterdruck p_{X} beträgt - in Abhängigkeit von den übrigen Reaktionsbedingungen, insbesondere je nach Lösungsmittel - beispielsweise 10⁻³ bis 10¹ mbar. Dadurch ist es beispielsweise möglich, das Lösungsmittel oder Lösungsmittelgemisch aus Schritt b) vollständig oder nahezu vollständig abzutrennen und zu rezyklisieren. Dies ist aus ökonomischer und ökologischer Sicht besonders vorteilhaft. Durch das Anlegen eines solchen geringen Unterdrucks werden auch während der Reaktion frei gewordenes *t*BuNH₂ und - in der Regel - nicht umgesetztes Amin HNR^{A}R^{B} entfernt. Um Letzteres quantitativ zu entfernen, ist - je nach Amin HNR^{A}R^{B} - gegebenenfalls ein größerer Unterdruck zu wählen.

Auf diese Weise, d. h. durch das Anlegen eines solchen geringen Unterdrucks, wurden im Falle der Isolierung von [W(N*t*Bu)₂(NMe₂)₂] nicht umgesetztes beziehungsweise als Lösungsmittel eingesetztes Dimethylamin und während der Umsetzung in Schritt b) frei gewordenes *tert*-Butylamin einfach und quantitativ entfernt. Eine weitere Aufreinigung der im jeweiligen Reaktionsbehältnis zurückbleibenden Verbindung [W(N*t*Bu)₂(NMe₂)₂], z. B. durch eine Umkondensation oder Destillation, war - laut NMR-spektroskopischer Analyse - nicht erforderlich. Denn weder im ¹H-NMR- noch im ¹³C-NMR-Spektrum von [W(N*t*Bu)₂(NMe₂)₂] wurden Fremdsignale durch Verunreinigungen, Neben- oder Zersetzungsprodukte beobachtet.

Die Isolierung von [W(N*t*Bu)₂(NR^{A}R^{B})₂] (I) kann auch einen oder mehrere der folgenden Verfahrensschritte umfassen: die Reduzierung des Volumens der Mutterlauge, d. h. Einengen, z. B. mittels "bulb-to-bulb", die Zugabe eines Lösungsmittels und/oder einen Lösungsmittelaustausch, um eine Fällung des Produktes aus der Mutterlauge zu erzielen und/oder Verunreinigungen und/oder Edukte zu entfernen, Waschen und Trocknen des Produktes. Des Weiteren kann vorgesehen sein, dass die Isolierung eine Destillation und/oder eine Sublimation und/oder eine Umkristallisation umfasst.

Für eine spätere Umsetzung oder Verwendung des Produkts [W(N*t*Bu)₂(NR^{A}R^{B})₂] (I) ist nach dessen Isolierung in der Regel keine Aufreinigung erforderlich. Es kann aber beispielsweise eine Umkondensation und/oder eine Destillation und/oder eine sublimative Aufreinigung vorgesehen sein.

Mit dem beanspruchten Verfahren zur Herstellung von Bis(*tert-*butylimido)bis(dialkylamido)wolfram-Verbindungen gemäß der allgemeinen Formel [W(N*t*Bu)₂(NR^{A}R^{B})₂] (I) werden die Nachteile des Standes der Technik überwunden. Insbesondere sind die mit dem beanspruchten Verfahren darstellbaren Verbindungen naturgemäß - nämlich aufgrund des Verzichts auf lithiumhaltige Edukte, wie z. B. Lithiumdimethylamid - frei von Lithiumverunreinigungen. Daher sind sie besonders gut als Präkursoren für die Abscheidung von Wolfram-Schichten oder Wolfram enthaltenden Schichten geeignet.

Die Aufgabe wird weiterhin gelöst durch Bis(*tert*-butylimido)bis(dialkylamido)wolfram-Verbindungen gemäß der allgemeinen Formel

[W(N*t*Bu)₂(NR^{A}R^{B})₂] (I)

wobei
R^{A} und R^{B} unabhängig voneinander ausgewählt sind aus der Gruppe bestehend aus linearen und verzweigten Alkylresten mit 1 bis 20 Kohlenstoffatomen, erhältlich nach einem Verfahren zur Herstellung von Bis(*tert*-butylimido)bis(dialkylamido)wolfram-Verbindungen gemäß einem der weiter oben beschriebenen Ausführungsbeispiele.

Die Bis(*tert*-butylimido)bis(dialkylamido)wolfram-Verbindungen gemäß der allgemeinen Formel [W(N*t*Bu)₂(NR^{A}R^{B})₂] (I) lassen sich vorteilhafterweise besonders einfach und kostengünstig in einer zweistufigen Synthese darstellen. Die Verbindungen des Typs [W(N*t*Bu)₂(NR^{A}R^{B})₂] (I) sind reproduzierbar bereits ohne weitere destillative und/oder sublimative Aufreinigung in hoher Reinheit herstellbar. Es kann aber beispielsweise eine Umkondensation und/oder eine Destillation und/oder eine sublimative Aufreinigung vorgesehen sein. Bis(*tert*-butylimido)bis(dialkylamido)wolfram-Verbindungen gemäß der allgemeinen Formel [W(N*t*Bu)₂(NR^{A}R^{B})₂] (I) erfüllen die Reinheitsanforderungen an Präkursoren zur Herstellung qualitativ hochwertiger Substrate, welche Wolfram-Schichten oder Wolfram enthaltende Schichten aufweisen. Insbesondere sind sie ohne Verwendung lithiumhaltiger Edukte, wie z. B. Lithiumdimethylamid, darstellbar und damit frei von Lithiumverunreinigungen erhältlich. Darüber hinaus sind die Bis(*tert-*butylimido)bis(dialkylamido)wolfram-Verbindungen auch im industriellen Maßstab darstellbar, wobei vergleichbare Ausbeuten und Reinheit der Zielverbindungen erreicht werden. Die reproduzierbare Ausbeute ist beispielsweise für [W(N*t*Bu)₂(NMe₂)₂] - auch im Falle einer Hochskalierung in Richtung industriellem Maßstab - zufriedenstellend.

Bis(*tert*-butylimido)bis(dialkylamido)wolfram-Verbindungen gemäß der allgemeinen Formel I, wie z. B. [W(N*t*Bu)₂(NMe₂)₂] und [W(N*t*Bu)₂(NEtMe)₂], sind bekannt. Verbindungen des Typs [W(N*t*Bu)₂(NR^{A}R^{B})₂], erhältlich nach einem Verfahren zur Herstellung von Bis(*tert-*butylimido)bis(dialkylamido)wolfram-Verbindungen gemäß einem der vorhergehend beschriebenen Ausführungsbeispiele, unterscheiden sich hinsichtlich ihrer Eigenschaften deutlich von denjenigen, welche mittels eines Verfahrens aus dem Stand der Technik herstellbar sind. So weisen die isolierten Zielverbindungen ohne aufwändige Reinigung eine mindestens so hohe Reinheit auf wie Verbindungen des Typs [W(N*t*Bu)₂(NR^{A}R^{B})₂], welche nach der Methode aus dem Stand der Technik dargestellt und mittels zweier fraktionierender Destillationen aufgereinigt wurden. Insbesondere sind sie naturgemäß - nämlich aufgrund des Verzichts auf lithiumhaltige Edukte, wie z. B. Lithiumdimethylamid, im Rahmen ihrer Darstellung - frei von Lithiumverunreinigungen. Wird das Edukt [W(N*t*Bu)₂(NH*t*Bu)₂] zunächst durch eine Umsetzung von WCl₆ mit *t*BuNH₂ in Gegenwart einer Hilfsbase dargestellt, fallen in Schritt a) und b) insgesamt - außer der jeweils gewünschten Zielverbindung - ausschließlich definierte, vergleichsweise einfach abtrennbaren Nebenprodukte an, in der Regel ein Ammoniumsalz, beispielsweise *t*BuNH₃Cl, und *t*BuNH₂ an. Des Weiteren kann überschüssiges, d. h. nicht umgesetztes Amin HNR^{A}R^{B}, zu entfernen sein. Die relativ einfache Abtrennbarkeit des in Schritt a) ausfallenden Ammoniumsalzes lässt sich auch mit der vorteilhaften Wahl eines aprotischen Lösungsmittels begründen. Werden zum Beispiel *n*-Hexan, *i*-Hexan und/oder n-Heptan als Solvens eingesetzt, fällt das Ammoniumsalz, z. B. *t*BuNH₃Cl quantitativ aus, während die Zielverbindung, z. B. [W(N*t*Bu)₂(NMe₂)₂], in Lösung bleibt. Eine Verunreinigung des jeweiligen Bis(*tert*-butylimido)bis(dialkylamido)wolfram-Komplexes durch die anfallende Ammoniumsalz-Fracht, beispielsweise *t*BuNH₃Cl, wird vorteilhafterweise vermieden. Das in Schritt b) des beanspruchten Verfahrens anfallende *t*BuNH₂ ist vergleichsweise leicht flüchtig und kann somit ebenfalls auf einfache Weise quantitativ entfernt werden, nämlich durch Anlegen eines geringfügigen Unterdrucks an einen Innenraum des jeweiligen Reaktionsbehältnisses. Dasselbe gilt in der Regel für das in Schritt b) jeweils im Überschuss verwendete HNR^{A}R^{B}, insbesondere für sehr leicht flüchtige Amine, wie z. B. HNMe₂. Weiterhin ist von Vorteil, dass es nicht zur Bildung undefinierbarer Nebenprodukte kommt, z. B. von Lithium-Wolframat-Komplexsalzen, welche sich nur schwierig oder gar nicht abtrennen lassen. Von besonderem Vorteil ist, dass sich das in Schritt a) angefallene Ammoniumsalz, beispielsweise *t*BuNH₃Cl, vor der Umsetzung in Schritt b) einfach und quantitativ durch einen Filtrationsschritt entfernen lässt. Die nach Durchführung von Schritt b) jeweils in Lösung befindliche Verbindung des Typs [W(N*t*Bu)₂(NR^{A}R^{B})₂] (I) kann beispielsweise durch einfaches Entfernen aller flüchtigen Bestandteile, isoliert werden. Zudem weist die isolierte Verbindung weder Amin-Verunreinigungen noch Reste des verwendeten Lösungsmittels oder Lösungsmittelgemisches auf. Die jeweilige Zielverbindung kann also nach der Isolierung ohne weitere Aufreinigung verwendet und/oder gelagert werden.

In einer Ausführungsform der Bis(*tert*-butylimido)bis(dialkylamido)wolfram-Verbindungen gemäß der allgemeinen Formel [W(N*t*Bu)₂(NR^{A}R^{B})₂] (I), erhältlich nach einem Verfahren zur Herstellung von Bis(*tert*-butylimido)bis(dialkylamido)wolfram-Verbindungen gemäß einem der weiter oben beschriebenen Ausführungsbeispiele, sind R^{A} und R^{B} unabhängig voneinander ausgewählt aus der Gruppe bestehend aus Me, Et, *n*Pr, *i*Pr, *n*Bu, *t*Bu, *s*Bu, *i*Bu, CH₂*s*Bu, CH₂*i*Bu, CH(Me)(*i*Pr), CH(Me)(*n*Pr), CH(Et)₂, C(Me)₂(Et), C₆H₁₁, CH₂C₆H₅ und C₆H₅. Beispielverbindungen sind [W(N*t*Bu)₂(NMe₂)₂] und [W(N*t*Bu)₂(NEtMe)₂].

In einer anderen Ausführungsform der Bis(*tert*-butylimido)bis(dialkylamido)wolfram-Verbindungen gemäß der allgemeinen Formel [W(N*t*Bu)₂(NR^{A}R^{B})₂] (I), erhältlich nach einem Verfahren zur Herstellung von Bis(*tert*-butylimido)bis(dialkylamido)wolfram-Verbindungen gemäß einem der weiter oben beschriebenen Ausführungsbeispiele, ist R ausgewählt aus der Gruppe bestehend aus 2-Fluorethyl, 2,2-Dichloro-2-fluoroethyl, 2-Chlorethyl, 2-Bromethyl, 2,2-Dibromethyl, 2,2,2-Tribromethyl, Hexafluorisopropyl, (2,2-Dichlorocyclopropyl)methyl und (2,2-Dichloro-1-phenylcyclopropyl)methyl.

Aufgrund ihrer Reinheit, insbesondere der Abwesenheit von Lithiumverunreinigungen, eigenen sich die mit dem beanspruchten Verfahren darstellbaren Verbindungen der allgemeinen Formel [W(N*t*Bu)₂(NR^{A}R^{B})₂] (I) besonders gut als Präkursoren zur Herstellung einer qualitativ hochwertigen Wolfram-Schicht oder Wolfram enthaltenden Schicht auf einer Oberfläche eines Substrats.

Die Aufgabe wird außerdem gelöst durch die Verwendung einer Bis(*tert-*butylimido)bis(dialkylamido)wolfram-Verbindung gemäß der allgemeinen Formel

[W(N*t*Bu)₂(NR^{A}R^{B})₂] (I),

wobei
R^{A} und R^{B} unabhängig voneinander ausgewählt sind aus der Gruppe bestehend aus linearen und verzweigten Alkylresten mit 1 bis 20 Kohlenstoffatomen,
▪ erhalten nach einem Verfahren zur Herstellung von Bis(*tert-*butylimido)bis(dialkylamido)wolfram-Verbindungen gemäß einem der vorhergehend beschriebenen Ausführungsbeispiele
   oder
▪ erhältlich nach einem Verfahren zur Herstellung von Bis(*tert-*butylimido)bis(dialkylamido)wolfram-Verbindungen gemäß einem der vorhergehend beschriebenen Ausführungsbeispiele
zur Herstellung einer Wolfram-Schicht oder einer Wolfram enthaltenden Schicht auf einer Oberfläche eines Substrats.

Dabei handelt es sich um ein Verfahren zur Herstellung einer Wolfram-Schicht oder einer Wolfram enthaltenden Schicht auf einer Oberfläche eines Substrats
unter Verwendung einer Bis(*tert*-butylimido)bis(dialkylamido)wolfram-Verbindung gemäß der allgemeinen Formel [W(N*t*Bu)₂(NR^{A}R^{B})₂] (I),
▪ erhalten nach einem Verfahren zur Herstellung von Bis(*tert-*butylimido)bis(dialkylamido)wolfram-Verbindungen gemäß einem der vorhergehend beschriebenen Ausführungsbeispiele
   oder
▪ erhältlich nach einem Verfahren zur Herstellung von Bis(*tert-*butylimido)bis(dialkylamido)wolfram-Verbindungen gemäß einem der vorhergehend beschriebenen Ausführungsbeispiele,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
   und
b) Abscheidung der Wolfram-Schicht oder der Wolfram enthaltenden Schicht auf der Oberfläche des Substrats.

Bei der Wolfram enthaltenden Schicht kann es sich beispielsweise um eine Schicht von WN, WCN, WSi, WSiN oder WO handeln.

Der Begriff Schicht ist gleichbedeutend mit dem Ausdruck Film und trifft keine Aussage über die Schichtdicke oder die Filmdicke. Als Substrat können z. B. Korundfolien oder dünne metallische Folien eingesetzt werden. Das Substrat kann selbst Teil eines Bauteils sein. Die Abscheidung der Wolfram-Schicht oder der Wolfram enthaltenden Schicht kann mittels eines Gasphasenabscheidungsverfahrens erfolgen, insbesondere mittels unterschiedlicher ALD-Verfahren (engl. *Atomic Layer Deposition*) und CVD-Methoden (engl. *Chemical Vapour Deposition*).

Die verwendeten Bis(tert-butylimido)bis(dialkylamido)wolfram-Verbindungen sind aufgrund ihrer hohen Reinheit besonders gut als Präkursoren zur Herstellung qualitativ hochwertiger Wolfram-Schichten und Wolfram enthaltender Schichten auf einer Oberfläche eines Substrats geeignet. Insbesondere sind sie - im Unterschied zu den mittels des bekannten Verfahrens erhältlichen Verbindungen - aufgrund des zu ihrer Herstellung eingesetzten Verfahrens naturgemäß frei von Lithiumverunreinigungen, welche für den Beschichtungsprozess und damit für die Performance der beschichteten Substrate nachteilig sind.

In einer Ausführungsform der Verwendung einer Bis(*tert-*butylimido)bis(dialkylamido)wolfram-Verbindung gemäß der allgemeinen Formel [W(N*t*Bu)₂(NR^{A}R^{B})₂] (I), erhalten oder erhältlich nach einem Verfahren zur Herstellung von Bis(*tert*-butylimido)bis(dialkylamido)wolfram-Verbindungen gemäß einem der vorhergehend beschriebenen Ausführungsbeispiele, zur Herstellung einer Wolfram-Schicht oder einer Wolfram enthaltenden Schicht auf einer Oberfläche eines Substrats bzw. in einer Ausführungsform des Verfahrens zur Herstellung einer Wolfram-Schicht oder einer Wolfram enthaltenden Schicht auf einer Oberfläche eines Substrats ist das Substrat ein Wafer. Der Wafer kann Silicium, Siliciumcarbid, Germanium, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung der Wolfram-Schicht oder der Wolfram enthaltenden Schicht kann auf der Oberfläche einer oder mehrerer Waferschichten vorgesehen sein.

Die Aufgabe wird ferner gelöst durch Bis(tert-butylimido)bis(dialkylamido)wolfram-Verbindungen gemäß der allgemeinen Formel

[W(N*t*Bu)₂(NR^{A}R^{B})₂] (I)

wobei
R^{A} und R^{B} unabhängig voneinander ausgewählt sind aus der Gruppe bestehend aus linearen und verzweigten Alkylresten mit 1 bis 20 Kohlenstoffatomen,
wobei
die Bis(*tert*-butylimido)bis(dialkylamido)wolfram-Verbindungen [W(N*t*Bu)₂(NMe₂)₂] und [W(N*t*Bu)₂(NEtMe)₂] ausgenommen sind.

Die Bis(*tert*-butylimido)bis(dialkylamido)wolfram-Verbindungen gemäß der allgemeinen Formel [W(N*t*Bu)₂(NR^{A}R^{B})₂] (I) lassen sich vorteilhafterweise besonders einfach und kostengünstig in einer zweistufigen Synthese darstellen. Die Verbindungen des Typs [W(N*t*Bu)₂(NR^{A}R^{B})₂] (I) sind reproduzierbar bereits ohne weitere destillative und/oder sublimative Aufreinigung in hoher Reinheit herstellbar. Es kann aber beispielsweise eine Umkondensation und/oder eine Destillation und/oder eine sublimative Aufreinigung vorgesehen sein. Die Bis(*tert*-butylimido)bis(dialkylamido)wolfram-Verbindungen gemäß der allgemeinen Formel [W(N*t*Bu)₂(NR^{A}R^{B})₂] (I) erfüllen die Reinheitsanforderungen an Präkursoren zur Herstellung qualitativ hochwertiger Substrate, welche Wolfram-Schichten oder Wolfram enthaltende Schichten aufweisen. Insbesondere sind sie ohne Verwendung lithiumhaltiger Edukte, wie z. B. Lithiumdimethylamid, darstellbar und damit frei von Lithiumverunreinigungen erhältlich. Darüber hinaus sind die Bis(*tert-*butylimido)bis(dialkylamido)wolfram-Verbindungen auch im industriellen Maßstab darstellbar, wobei vergleichbare Ausbeuten und Reinheit der Zielverbindungen erreicht werden.

Aufgrund ihrer Reinheit, insbesondere der Abwesenheit von Lithiumverunreinigungen, sowie der Tatsache, dass sie im großtechnischen Maßstab einfach und kostengünstig herstellbar sind, eigenen sich Verbindungen gemäß der allgemeinen Formel [W(N*t*Bu)₂(NR^{A}R^{B})₂] (I) besonders gut als Präkursoren zur Herstellung einer qualitativ hochwertigen Wolfram-Schicht oder Wolfram enthaltenden Schicht auf einer Oberfläche eines Substrats.

Die Aufgabe wird außerdem gelöst durch die Verwendung von Bis(*tert-*butylimido)bis(dialkylamido)wolfram-Verbindungen gemäß der allgemeinen Formel

[W(N*t*Bu)₂(NR^{A}R^{B})₂] (I),

wobei
R^{A} und R^{B} unabhängig voneinander ausgewählt sind aus der Gruppe bestehend aus linearen und verzweigten Alkylresten mit 1 bis 20 Kohlenstoffatomen,
zur Herstellung einer Wolfram-Schicht oder einer Wolfram enthaltenden Schicht auf einer Oberfläche eines Substrats,
wobei die Bis(*tert*-butylimido)bis(dialkylamido)wolfram-Verbindung [W(N*t*Bu)₂(NMe₂)₂] ausgenommen ist.

Dabei handelt es sich um ein Verfahren zur Herstellung einer Wolfram-Schicht oder einer Wolfram enthaltenden Schicht auf einer Oberfläche eines Substrats
unter Verwendung einer Bis(*tert*-butylimido)bis(dialkylamido)wolfram-Verbindung gemäß der allgemeinen Formel [W(N*t*Bu)₂(NR^{A}R^{B})₂] (I), wobei
R^{A} und R^{B} unabhängig voneinander ausgewählt sind aus der Gruppe bestehend aus linearen und verzweigten Alkylresten mit 1 bis 20 Kohlenstoffatomen,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I)
   und
b) Abscheidung der Wolfram-Schicht oder der Wolfram enthaltenden Schicht auf der Oberfläche des Substrats.

Bei der Wolfram enthaltenden Schicht kann es sich beispielsweise um eine Schicht von WN, WCN, WSi, WSiN oder WO handeln.

Der Begriff Schicht ist gleichbedeutend mit dem Ausdruck Film und trifft keine Aussage über die Schichtdicke oder die Filmdicke. Als Substrat können z. B. Korundfolien oder dünne metallische Folien eingesetzt werden. Das Substrat kann selbst Teil eines Bauteils sein. Die Abscheidung der Wolfram-Schicht oder der Wolfram enthaltenden Schicht kann mittels eines Gasphasenabscheidungsverfahrens erfolgen, insbesondere mittels unterschiedlicher ALD-Verfahren (engl. *Atomic Layer Deposition*) und CVD-Methoden (engl. *Chemical Vapour Deposition*).

Die verwendeten Bis(tert-butylimido)bis(dialkylamido)wolfram-Verbindungen sind aufgrund ihrer hohen Reinheit besonders gut als Präkursoren zur Herstellung qualitativ hochwertiger Wolfram-Schichten und Wolfram enthaltender Schichten auf einer Oberfläche eines Substrats geeignet. Insbesondere sind sie - im Unterschied zu den mittels des bekannten Verfahrens erhältlichen Verbindungen - aufgrund des zu ihrer Herstellung eingesetzten Verfahrens naturgemäß frei von Lithiumverunreinigungen, welche für den Beschichtungsprozess und damit für die Performance der beschichteten Substrate nachteilig sind.

In einer Ausführungsform der Verwendung einer Bis(*tert-*butylimido)bis(dialkylamido)wolfram-Verbindung gemäß der allgemeinen Formel [W(N*t*Bu)₂(NR^{A}R^{B})₂] (I) zur Herstellung einer Wolfram-Schicht oder einer Wolfram enthaltenden Schicht auf einer Oberfläche eines Substrats bzw. in einer Ausführungsform des Verfahrens zur Herstellung einer Wolfram-Schicht oder einer Wolfram enthaltenden Schicht auf einer Oberfläche eines Substrats ist das Substrat ein Wafer. Der Wafer kann Silicium, Siliciumcarbid, Germanium, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung der Wolfram-Schicht oder der Wolfram enthaltenden Schicht kann auf der Oberfläche einer oder mehrerer Waferschichten vorgesehen sein.

Die Aufgabe wird weiterhin gelöst durch ein Substrat, welches auf einer Oberfläche eine Wolfram-Schicht oder eine Wolfram enthaltende Schicht aufweist,
wobei die Wolfram-Schicht oder die Wolfram enthaltende Schicht herstellbar ist unter Verwendung einer Bis(*tert*-butylimido)bis(dialkylamido)wolfram-Verbindung gemäß der allgemeinen Formel [W(N*t*Bu)₂(NR^{A}R^{B})₂] (I),
erhalten oder erhältlich nach einem Verfahren zur Herstellung von Bis(*tert-*butylimido)bis(dialkylamido)wolfram-Verbindungen gemäß einem der weiter oben beschriebenen Ausführungsbeispiele,
wobei R^{A} und R^{B} unabhängig voneinander ausgewählt sind aus der Gruppe bestehend aus linearen und verzweigten Alkylresten mit 1 bis 20 Kohlenstoffatomen.

Außerdem wird die Aufgabe gelöst durch ein Substrat, welches auf einer Oberfläche eine Wolfram-Schicht oder eine Wolfram enthaltende Schicht aufweist,
wobei die Wolfram-Schicht oder die Wolfram enthaltende Schicht herstellbar ist unter Verwendung einer Bis(*tert*-butylimido)bis(dialkylamido)wolfram-Verbindung gemäß der allgemeinen Formel [W(N*t*Bu)₂(NR^{A}R^{B})₂] (I),
wobei R^{A} und R^{B} unabhängig voneinander ausgewählt sind aus der Gruppe bestehend aus linearen und verzweigten Alkylresten mit 1 bis 20 Kohlenstoffatomen,
wobei die Bis(*tert*-butylimido)bis(dialkylamido)wolfram-Verbindung [W(N*t*Bu)₂(NMe₂)₂] ausgenommen ist.

Bei der Wolfram enthaltenden Schicht kann es sich beispielsweise um eine Schicht von WN, WCN, WSi, WSiN oder WO handeln.

Der Begriff Schicht ist gleichbedeutend mit dem Ausdruck Film und trifft keine Aussage über die Schichtdicke oder die Filmdicke. Als Substrat können z. B. Korundfolien oder dünne metallische Folien eingesetzt werden. Das Substrat kann selbst Teil eines Bauteils sein. Die Abscheidung der Wolfram-Schicht oder der Wolfram enthaltenden Schicht kann mittels eines Gasphasenabscheidungsverfahrens erfolgt sein, insbesondere mittels unterschiedlicher ALD-Verfahren (engl. *Atomic Layer Deposition*) und CVD-Methoden (engl. *Chemical Vapour Deposition*).

Die verwendeten Bis(*tert*-butylimido)bis(dialkylamido)wolfram-Verbindungen sind aufgrund ihrer hohen Reinheit besonders gut als Präkursoren zur Herstellung qualitativ hochwertiger Wolfram-Schichten und Wolfram enthaltender Schichten geeignet. Insbesondere sind sie - im Unterschied zu den mittels des bekannten Verfahrens erhältlichen Verbindungen - aufgrund des zu ihrer Herstellung eingesetzten Verfahrens naturgemäß frei von Lithiumverunreinigungen, welche für den Beschichtungsprozess und damit für die Performance der beschichteten Substrate nachteilig sind.

In einer Ausführungsform des Substrats, welches auf einer Oberfläche eine Wolfram-Schicht oder eine Wolfram enthaltende Schicht aufweist, wobei die Wolfram-Schicht oder die Wolfram enthaltende Schicht herstellbar ist unter Verwendung einer Bis(*tert-*butylimido)bis(dialkylamido)wolfram-Verbindung gemäß der allgemeinen Formel [W(N*t*Bu)₂(NR^{A}R^{B})₂] (I), insbesondere erhalten oder erhältlich nach einem Verfahren zur Herstellung von Bis(tert-butylimido)bis(dialkylamido)wolfram-Verbindungen gemäß einem der weiter oben beschriebenen Ausführungsbeispiele, ist das Substrat ein Wafer. Der Wafer kann Silicium, Siliciumcarbid, Germanium, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung der Wolfram-Schicht oder der Wolfram enthaltenden Schicht kann auf der Oberfläche einer oder mehrerer Waferschichten vorgesehen sein.

Die Aufgabe wird ferner gelöst durch die Verwendung einer Bis(*tert-*butylimido)bis(dialkylamido)wolfram-Verbindung gemäß der allgemeinen Formel [W(N*t*Bu)₂(NR^{A}R^{B})₂] (I), erhalten oder erhältlich nach einem Verfahren zur Herstellung von Bis(*tert*-butylimido)bis(dialkylamido)wolfram-Verbindungen gemäß einem der vorhergehend beschriebenen Ausführungsbeispiele, zur Herstellung eines elektronischen Bauelementes. Im Zusammenhang mit der vorliegenden Erfindung ist mit dem Begriff "elektronisches Bauelement" auch "elektronisches Bauteil" gemeint.

Dabei handelt es sich um ein Verfahren zur Herstellung eines elektronischen Bauelementes, unter Verwendung einer Bis(*tert*-butylimido)bis(dialkylamido)wolfram-Verbindung gemäß der allgemeinen Formel [W(N*t*Bu)₂(NR^{A}R^{B})₂] (I), erhalten oder erhältlich nach einem Verfahren zur Herstellung von Bis(*tert-*butylimido)bis(dialkylamido)wolfram-Verbindungen gemäß einem der vorhergehend beschriebenen Ausführungsbeispiele,
wobei
R^{A} und R^{B} unabhängig voneinander ausgewählt sind aus der Gruppe bestehend aus linearen und verzweigten Alkylresten mit 1 bis 20 Kohlenstoffatomen,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
b) Abscheidung einer Wolfram-Schicht oder einer Wolfram enthaltenden Schicht auf einer Oberfläche eines Substrats,
   und
c) Fertigstellung des elektronischen Bauelementes.

Weiterhin wird die Aufgabe gelöst durch ein Verfahren zur Herstellung eines elektronischen Bauelementes, unter Verwendung einer Bis(*tert*-butylimido)bis(dialkylamido)wolfram-Verbindung gemäß der allgemeinen Formel [W(N*t*Bu)₂(NR^{A}R^{B})₂] (I), unter Verwendung einer Bis(*tert*-butylimido)bis(dialkylamido)wolfram-Verbindung gemäß der allgemeinen Formel [W(N*t*Bu)₂(NR^{A}R^{B})₂] (I),
wobei
R^{A} und R^{B} unabhängig voneinander ausgewählt sind aus der Gruppe bestehend aus linearen und verzweigten Alkylresten mit 1 bis 20 Kohlenstoffatomen,
wobei die Bis(*tert*-butylimido)bis(dialkylamido)wolfram-Verbindung [W(N*t*Bu)₂(NMe₂)₂] ausgenommen ist,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
b) Abscheidung einer Wolfram-Schicht oder einer Wolfram enthaltenden Schicht auf einer Oberfläche eines Substrats,
   und
c) Fertigstellung des elektronischen Bauelementes.

Im Zusammenhang mit der vorliegenden Erfindung ist mit dem Begriff "elektronisches Bauelement" auch "elektronisches Bauteil" gemeint.

Aufgrund ihrer Reinheit sind die verwendeten Bis(*tert*-butylimido)bis(dialkylamido)wolfram-Verbindungen besonders gut als Präkursoren zur Herstellung qualitativ hochwertiger Substrate geeignet, welche Wolfram-Schichten oder Wolfram enthaltende Schichten aufweisen. Diese Substrate werden zur Herstellung elektronischer Bauelemente und elektronischer Bauteile verwendet. Zudem sind verwendeten Bis(*tert-*butylimido)bis(dialkylamido)wolfram-Verbindungen mittels einer weiter oben beschriebenen zweistufigen Synthese besonders einfach und kostengünstig in guten und reproduzierbaren Ausbeuten und hoher Reinheit darstellbar. Insbesondere sind sie mittels des hier beanspruchten Verfahrens lithiumfrei darstellbar. Mithin sind sie für den Einsatz im industriellen Maßstab geeignet.

Mit dem beanspruchten Verfahren sind definierte Bis(*tert-*butylimido)bis(dialkylamido)wolfram-Verbindungen auf einfache, kostengünstige und reproduzierbare Art und Weise in hoher Reinheit und guten Ausbeuten darstellbar. Die in einer zweistufigen Synthese herstellbaren Verbindungen weisen bereits nach ihrer Isolierung laut ¹H-NMR-Spektren eine hohe Reinheit auf. Dazu bedarf es keiner aufwändigen Reinigung des jeweils isolierten Rohprodukts durch fraktionierende Destillation und/oder Sublimation. Allerdings kann eine Umkondensation und/oder eine Destillation und/oder eine Sublimation und/oder eine Kristallisation und/oder eine Umkristallisation vorgesehen sein. Aufgrund ihrer hohen Reinheit, insbesondere der Abwesenheit von Lithiumverunreinigungen und Verunreinigungen durch anorganische Salze, sind die mit dem beanspruchten Verfahren darstellbaren Verbindungen für den Einsatz als Präkursoren zur Herstellung qualitativ hochwertiger Substrate geeignet, welche Wolfram-Schichten oder Wolfram enthaltende Schichten aufweisen. Die Verbindungen der allgemeinen Formel [W(N*t*Bu)₂(NR^{A}R^{B})₂] (I) können aufgrund ihrer hohen Reinheit zum Beispiel zur Herstellung qualitativ hochwertiger Kontaktmaterialien, Barriereschichten, Elektroden für Dünnschichtkondensatoren und Feldeffekttransistoren, jeweils bestehend aus oder umfassend z. B. Wolframnitrid-Schichten, eingesetzt werden. Zudem zeichnet sich das beanspruchte Verfahren dadurch aus, dass es - mit vergleichbarer Ausbeute und Reinheit der Zielverbindungen - auch im industriellen Maßstab durchgeführt werden kann. Insgesamt ist das beanspruchte Verfahren unter ökologischen und ökonomischen Aspekten als zufriedenstellend zu bewerten.

Weitere Merkmale, Einzelheiten und Vorteile der Erfindung ergeben sich aus dem Wortlaut der Ansprüche sowie aus der folgenden Beschreibung von Ausführungsbeispielen.

### Arbeitsvorschriften zur Synthese von [W(NtBu)₂(NHtBu)₂] und [W(NtBu)₂(NMe₂)₂]

### Materialien und Methoden:

Alle Reaktionen wurden unter Schutzgasatmosphäre durchgeführt. Dabei wurde mit Hilfe gängiger Schlenk-Techniken gearbeitet, wobei Stickstoff oder Argon als Schutzgas eingesetzt wurden. Die entsprechenden Vakuum-Rechen bzw. Schlenk-Linien waren mit Drehschieberpumpen der Fa. Vacuubrand verbunden. Das Abwiegen und Lagern von Edukten, Reagenzien und synthetisierten Produkten erfolgte in Handschuhkästen der Fa. MBraun (Typ *MB 150 BG-1* oder *Lab Master 130*) unter Stickstoffatmosphäre.

Das deuterierte Lösungsmittel C₆D₆ wurde über einer K/Na Legierung absolutiert, anschließend kondensiert und über Molsieb gelagert.

Alle kernresonanzspektroskopischen Messungen wurden in Automation an einem Gerät des Typs AV II 300 oder im Handbetrieb an einem Gerät des Typs AV III HD 250 oder AV III HD 300 durchgeführt. ¹H- und ¹³C-NMR-Spektren wurden auf das entsprechende Restprotonensignal des Lösungsmittels als interner Standard kalibriert: ¹H-NMR-Spektren: C₆D₆: 7.16 ppm (s); ¹³C-NMR-Spektren: C₆D₆: 128.0 ppm (tr). Die chemischen Verschiebungen werden in ppm angegeben und beziehen sich auf die *δ*-Skala. Alle Signale werden entsprechend ihres Aufspaltungsmusters mit den folgenden Abkürzungen versehen: s (Singulett).

Die Messungen von Infrarotspektren erfolgten in Substanz in der Regel an einem Alpha ATR-IR-Spektrometer der Fa. Bruker. Die Absorptionsbanden sind angegeben in Wellenzahl (cm⁻¹) und die Intensität wird mit folgenden Abkürzungen beschrieben: w (schwach), m (mittelstark), st (stark), vst (sehr stark). Normiert wurden die Spektren stets auf die intensitätsstärkste Bande.

Die Elementaranalysen wurden an einem Vario-Micro-Cube Verbrennungsgerät der Fa. Elementar durchgeführt. Die Probenvorbereitung erfolgte in einem mit Stickstoff gefluteten Handschuhkasten durch Einwiegen der Substanz in Zinn-Tiegel, welche kalt verschweißt und bis zur Messung unter Schutzgasatmosphäre gelagert wurden. Die Elemente Wasserstoff, Kohlenstoff und Stickstoff wurden über eine Verbrennungsanalyse ermittelt, wobei die Angabe stets in Massenprozent erfolgt.

Alle EI-massenspektrometrischen Untersuchungen wurden an einem AccuTOF GCv Spektrometer der Fa. Joel durchgeführt. Luft- und feuchtigkeitsempfindliche Proben wurden in einem Handschuhkasten in Tiegeln präpariert und bis zur Messung unter Schutzgasatmosphäre gelagert. Im Falle hochaufgelöster Spektren wird jeweils das Signal mit der höchsten Intensität des Isotopenmusters angegeben.

Die thermogravimetrischen Untersuchungen wurden an einem TGA/DSC 3+ STAR System der Fa. Mettler Toledo durchgeführt. Dabei wurde bei jeder TGA- eine gekoppelte SDTA-Messung durchgeführt. Die Probe wurde je nach Methode bzw. je nach Aggregatzustand in einem Aluminiumoxid-, Aluminium- oder Saphirtiegel gemessen. Die Probe wurde mit einer bestimmten Heizrate von 25 °C bis zur Endtemperatur erhitzt. Die Auswertung der erhaltenen Spektren erfolgte mit STARe Software der Fa. Mettler Toledo.

### Ausführungsbeispiel 1: Darstellung von [W(NtBu)₂(NHtBu)₂]

Die Synthese erfolgte in Anlehnung an eine Vorschrift von Nugent und Harlow. (W. A. Nugent, R. L. Harlow, Inorg. Chem. 1980, 19, 777 - 779)

*t*BuNH₂ (21,0 g, 287 mmol, 11,4 eq) wurde in 350 mL *n*-Hexan vorgelegt und bei Raumtemperatur portionsweise mit WCl₆ (10,0 g, 25,2 mmol, 1,00 eq) versetzt. Das Reaktionsgemisch verfärbte sich dabei schwach gelb, während ein farbloser Feststoff ausfiel. Das Reaktionsgemisch wurde für 72 h bei Raumtemperatur gerührt. Der ausgefallene Feststoff wurde abfiltriert und das Lösungsmittel des Filtrats im Feinvakuum (10⁻³ bis 10⁻² mbar) entfernt. Das Produkt wurde bei 65 °C im Feinvakuum (10⁻³ bis 10⁻² mbar) sublimativ aufgereinigt und als schwach gelber Feststoff mit einer Ausbeute von 71% (8,28 g, 17,6 mmol) erhalten.

Alternativ kann das Produkt bei -24 °C aus Toluol kristallisiert werden. Dann beträgt die Ausbeute jedoch lediglich 45 - 51%.
**¹H-NMR** (C₆D₆, 300 MHz, 300 K): *δ*/ppm = 1,27 (s, 18 H, NC*Me₃*), 1,45 (s, 18 H, NHC*Me₃*), 5,22 (s, 2 H, N*H*CMe₃); **¹³C-NMR** (C₆D₆, 75 MHz, 300 K): *δ*/ppm = 33,7 (NC*Me₃*), 33,8 (NHC*Me₃*), 53,3 (NH*C*Me₃), 66,0 (N*C*Me₃); **TGA** (T_{S} = 25 °C, T_{E} = 900 °C, 10 °C/min): Stufen: 1, 3%-Abbau: 125,3 °C, T_{MA}: 195,7 °C, Gesamtmasseabbau: 95,0%; **SDTA:** T_{M(Onset)}: 85,3 °C, T_{M(max.)}: 90,0 °C, T_{D(Onset)}: 137,3 °C, T_{D(max.)}: 150,8 °C.

### Ausführungsbeispiel 2: Darstellung von [W(NtBu)₂(NMe₂)₂]

[W(N*t*Bu)₂(NH*t*Bu)₂] (250 mg, 0,53 mmol, 1,00 eq) wurde vorgelegt, in flüssigem Stickstoff eingefroren und zuvor nach Standardmethoden getrocknetes HNMe₂ (5,13 g, 114 mmol, 215 eq) einkondensiert. Das Reaktionsgemisch wurde langsam auf -20 °C erwärmt, bis [W(N*t*Bu)₂(NH*t*Bu)₂] in Lösung ging. Die hellgelbe Lösung wurde auf -15 °C erwärmt und für 2 h gerührt. Das orangefarbene Reaktionsgemisch wurde auf Raumtemperatur gebracht, wobei überschüssiges HNMe₂ verdampfte. Im Feinvakuum (10⁻³ bis 10¹ mbar) wurden Reste von HNMe₂ sowie entstandenes *t*BuNH₂ entfernt. Das Produkt wurde in Form einer orangefarbenen Flüssigkeit mit einer Ausbeute von 93% (206 mg, 0,50 mmol) erhalten.
**¹H-NMR** (C₆D₆, 300 MHz, 300 K): *δ*/ppm = 1,41 (s, 18 H, C*Me₃*), 3,51 (s, 12 H, N*Me₂*); **¹³C-NMR** (C₆D₆, 75 MHz, 300 K): *δ*/ppm = 34,1 (C*Me₃*), 53,8 (N*Me₂*), 66,2 (*C*Me₃); **IR:** *υ̃*/cm⁻¹ = 2965 (m), 2919 (m), 2896 (m), 2857 (m), 2821 (m), 2776 (m), 1450 (m), 1421 (w), 1354 (m), 1288 (m), 1240 (vst), 1212 (st), 1159 (w), 1142 (w), 1125 (w), 1054 (w), 1024 (w), 975 (st), 958 (vst), 806 (w), 780 (w), 696 (w), 636 (w), 561 (st), 476 (w); **Elementaranalyse** für C₁₂H₃₀N₄W: berechnet: C: 34,79%, H: 7,30%, N: 13,53%, gefunden: C: 33,21%, H: 6,74%, N: 14,89%; **HR-EI-MS:** berechnet für C₁₂H₃₀N₄W: 414,1979 *m*/*z,* gefunden: 414,1964 *m*/*z*; **TGA** (T_{S} = 25 °C, T_{E} = 600 °C, 10 °C/min): Stufen: 1, 3%-Abbau: 120,7 °C, T_{MA}: 185,2 °C, Gesamtmasseabbau: 97,3%; **SDTA:** T_{D(Onset)}: 150,3 °C, T_{D(max.)}: 186,9 °C.

Die Erfindung ist nicht auf eine der vorbeschriebenen Ausführungsformen beschränkt, sondern in vielfältiger Weise abwandelbar.

Man erkennt, dass die Erfindung eine zweistufige Synthese zur Herstellung von Bis(*tert-*butylimido)bis(dialkylamido)wolfram-Verbindungen gemäß der allgemeinen Formel [W(N*t*Bu)₂(NR^{A}R^{B})₂] (I) betrifft, ausgehend von [W(N*t*Bu)₂(NH*t*Bu)₂]. Die Erfindung betrifft weiterhin Verbindungen gemäß der allgemeinen Formel [W(N*t*Bu)₂(NR^{A}R^{B})₂] (I), erhältlich nach dem beanspruchten Verfahren, Verbindungen gemäß der allgemeinen Formel [W(N*t*Bu)₂(NR^{A}R^{B})₂] (I), mit Ausnahme von [W(N*t*Bu)₂(NMe₂)₂] und [W(N*t*Bu)₂(NEtMe)₂], die Verwendung einer Verbindung [W(N*t*Bu)₂(NR^{A}R^{B})₂] (I) sowie ein Substrat, welches auf einer Oberfläche eine Wolfram-Schicht oder eine Wolfram enthaltende Schicht aufweist.

Mit dem beschriebenen Verfahren sind definierte Bis(*tert-*butylimido)bis(dialkylamido)wolfram-Verbindungen des Typs [W(N*t*Bu)₂(NR^{A}R^{B})₂] (I) auf einfache, effiziente, kostengünstige und reproduzierbare Weise in hoher Reinheit und guten Ausbeuten darstellbar. Das Verfahren ist auch im industriellen Maßstab durchführbar. Die Verbindungen weisen bereits nach ihrer Isolierung - ohne aufwändige Aufreinigung - keine NMR-spektroskopisch detektierbaren Verunreinigungen auf. Sie eignen sich aufgrund ihrer hohen Reinheit, insbesondere der Abwesenheit von Lithiumverunreinigungen, als Präkursoren zur Herstellung qualitativ hochwertiger Substrate, welche Wolfram-Schichten oder Wolfram enthaltende Schichten aufweisen. Beispielsweise sind sie zur Herstellung qualitativ hochwertiger Kontaktmaterialien oder Barriereschichten, umfassend z. B. Wolframnitrid, geeignet.

Sämtliche aus den Ansprüchen, der Beschreibung und den Figuren hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

## Patentansprüche

1. Verfahren zur Herstellung von Bis(*tert*-butylimido)bis(dialkylamido)wolfram-Verbindungen
gemäß der allgemeinen Formel
[W(N*t*Bu)₂(NR^{A}R^{B})₂] (I),
wobei
R^{A} und R^{B} unabhängig voneinander ausgewählt sind aus der Gruppe bestehend aus linearen und verzweigten Alkylresten mit 1 bis 20 Kohlenstoffatomen,
umfassend die Schritte:
a) Zurverfügungstellung von [W(N*t*Bu)₂(NH*t*Bu)₂]
und
b) Umsetzung von [W(N*t*Bu)₂(NH*t*Bu)₂] aus Schritt a) mit einem Amin gemäß der allgemeinen Formel HNR^{A}R^{B} in einem Lösungsmittel M_{U},
wobei
- R^{A} und R^{B} unabhängig voneinander ausgewählt sind aus der Gruppe bestehend aus linearen und verzweigten Alkylresten mit 1 bis 20 Kohlenstoffatomen,
und
- ein molares Verhältnis [W(N*t*Bu)₂(NH*t*Bu)₂] : HNR^{A}R^{B} < 1 : 2 ist.

2. Verfahren nach Anspruch 1, wobei die Zurverfügungstellung von [W(N*t*Bu)₂(NH*t*Bu)₂] eine Umsetzung von WCl₆ mit *t*BuNH₂ in Gegenwart einer Hilfsbase in einem aprotischen Lösungsmittel M_{A} umfasst,
wobei ein molares Verhältnis WCl₆ : *t*BuNH₂ ≤ 1 : 4 ist.

3. Verfahren nach Anspruch 2, wobei die Hilfsbase *t*BuNH₂ umfasst oder ist.

4. Verfahren nach Anspruch 2 oder 3, wobei das aprotische Lösungsmittel M_{A} ausgewählt ist aus der Gruppe bestehend aus Kohlenwasserstoffen, Benzol und Benzolderivaten.

5. Verfahren nach einem der Ansprüche 2 bis 4, wobei das aprotische Lösungsmittel M_{A} ausgewählt ist aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol, Xylol sowie deren Isomeren.

6. Verfahren nach einem der Ansprüche 2 bis 5, wobei die Umsetzung von WCl₆ mit *t*BuNH₂ in Gegenwart der Hilfsbase in dem aprotischen Lösungsmittel M_{A} folgende Schritte umfasst:
i) Bereitstellen einer Lösung von *t*BuNH₂ in dem aprotischen Lösungsmittel M_{A},
ii) Hinzufügen der Hilfsbase,
iii) Hinzufügen von WCl₆,
wobei während des Hinzufügens und/oder nach dem Hinzufügen von WCl₆ eine Reaktion von WCl₆ mit *t*BuNH₂ erfolgt.

7. Verfahren nach einem der Ansprüche 2 bis 6, wobei die Umsetzung von WCl₆ mit *t*BuNH₂ in Gegenwart der Hilfsbase in dem aprotischen Lösungsmittel M_{A} bei einer Temperatur T_{U} durchgeführt wird, wobei die Temperatur T_{U} zwischen -30 °C und 100 °C beträgt.

8. Verfahren nach einem der Ansprüche 2 bis 7, wobei vor der Umsetzung von [W(N*t*Bu)₂(NH*t*Bu)₂] in Schritt b) ein Filtrationsschritt durchgeführt wird.

9. Verfahren nach einem der Ansprüche 1 bis 8, wobei vor der Umsetzung von [W(N*t*Bu)₂(NH*t*Bu)₂] in Schritt b) eine Isolierung von [W(N*t*Bu)₂(NH*t*Bu)₂] durchgeführt wird.

10. Verfahren nach einem der Ansprüche 1 bis 9, wobei in Schritt b) das molare Verhältnis [W(N*t*Bu)₂(NH*t*Bu)₂] : HNR^{A}R^{B} ≤ 1 : 4 ist.

11. Verfahren nach einem der Ansprüche 1 bis 10, wobei das Lösungsmittel M_{U} ein aprotisches Lösungsmittel umfasst.

12. Verfahren nach einem der Ansprüche 2 bis 11, wobei das Lösungsmittel M_{U} mit dem aprotischen Lösungsmittel M_{A} mischbar oder identisch ist.

13. Verfahren nach Anspruch 11 oder 12, wobei das aprotische Lösungsmittel, welches das Lösungsmittel M_{U} umfasst, ausgewählt ist aus der Gruppe bestehend aus Kohlenwasserstoffen, Benzol und Benzolderivaten.

14. Verfahren nach einem der Ansprüche 11 bis 13, wobei das aprotische Lösungsmittel, welches das Lösungsmittel M_{U} umfasst, ausgewählt ist aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol, Xylol sowie deren Isomeren.

15. Verfahren nach einem der Ansprüche 1 bis 14, wobei das Lösungsmittel M_{U} ein reaktives Lösungsmittel umfasst.

16. Verfahren nach Anspruch 15, wobei das reaktive Lösungsmittel das Amin HNR^{A}R^{B} umfasst.

17. Verfahren nach einem der Ansprüche 1 bis 16, wobei Schritt b) bei einer Temperatur T_{R} und/oder einem Druck p_{R} durchgeführt wird,
wobei bei der Temperatur T_{R} und/oder dem Druck p_{R} wenigstens ein Anteil eines Stoffmengenanteils des Amins NHR^{A}R^{B} in flüssiger oder gelöster Form vorliegt.

18. Verfahren nach einem der Ansprüche 1 bis 17, wobei in Schritt b) die Umsetzung von [W(N*t*Bu)₂(NH*t*Bu)₂] aus Schritt a) mit dem Amin HNR^{A}R^{B} folgende Schritte umfasst:
i) Bereitstellen von [W(N*t*Bu)₂(NH*t*Bu)₂]
- als Feststoff
oder
- als Lösung oder Suspension in dem Lösungsmittel M_{U},
und
ii) Hinzufügen des Amins HNR^{A}R^{B},
wobei während des Hinzufügens und/oder nach dem Hinzufügen des Amins HNR^{A}R^{B} eine Reaktion von [W(N*t*Bu)₂(NH*t*Bu)₂] mit dem Amin HNR^{A}R^{B} erfolgt.

19. Verfahren nach Anspruch 18, wobei das Amin HNR^{A}R^{B}
- als Gas oder Flüssigkeit
oder
- in dem Lösungsmittel M_{U} gelöst
hinzugefügt wird.

20. Verfahren nach Anspruch 18 oder 19, wobei eine Temperatur T_{C} während des Hinzufügens und/oder nach dem Hinzufügen des Amins HNR^{A}R^{B} zwischen -60 °C und 50 °C beträgt.

21. Verfahren nach einem der Ansprüche 1 bis 20, wobei nach Schritt b) eine Isolierung von [W(N*t*Bu)₂(NR^{A}R^{B})₂] (I) erfolgt.

22. Bis(*tert*-butylimido)bis(dialkylamido)wolfram-Verbindungen gemäß der allgemeinen Formel
[W(N*t*Bu)₂(NR^{A}R^{B})₂] (I),
erhältlich nach einem Verfahren gemäß einem der Ansprüche 1 bis 21.

23. Bis(*tert*-butylimido)bis(dialkylamido)wolfram-Verbindungen gemäß der allgemeinen Formel
[W(N*t*Bu)₂(NR^{A}R^{B})₂] (I),
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(*tert*-butylimido)bis(dialkylamido)wolfram-Verbindungen [W(N*t*Bu)₂(NMe₂)₂] und [W(N*t*Bu)₂(NEtMe)₂] ausgenommen sind.

24. Verwendung einer Bis(*tert*-butylimido)bis(dialkylamido)wolfram-Verbindung gemäß der allgemeinen Formel [W(N*t*Bu)₂(NR^{A}R^{B})₂] (I),
▪ erhalten nach einem Verfahren gemäß einem der Ansprüche 1 bis 21,
oder
▪ erhältlich nach einem Verfahren gemäß einem der Ansprüche 1 bis 21,
zur Herstellung einer Wolfram-Schicht oder einer Wolfram enthaltenden Schicht auf einer Oberfläche eines Substrats.

25. Verfahren zur Herstellung einer Wolfram-Schicht oder einer Wolfram enthaltenden Schicht auf einer Oberfläche eines Substrats
unter Verwendung einer Bis(t*ert*-butylimido)bis(dialkylamido)wolfram-Verbindung gemäß der allgemeinen Formel [W(N*t*Bu)₂(NR^{A}R^{B})₂] (I),
▪ erhalten nach einem Verfahren gemäß einem der Ansprüche 1 bis 21,
oder
▪ erhältlich nach einem Verfahren gemäß einem der Ansprüche 1 bis 21,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
und
b) Abscheidung der Wolfram-Schicht oder der Wolfram enthaltenden Schicht auf der Oberfläche des Substrats.

26. Verwendung einer Bis(*tert*-butylimido)bis(dialkylamido)wolfram-Verbindung gemäß der allgemeinen Formel [W(N*t*Bu)₂(NR^{A}R^{B})₂] (I),
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(*tert*-butylimido)bis(dialkylamido)wolfram-Verbindung [W(N*t*Bu)₂(NMe₂)₂] ausgenommen ist,
zur Herstellung einer Wolfram-Schicht oder einer Wolfram enthaltenden Schicht auf einer Oberfläche eines Substrats.

27. Verfahren zur Herstellung einer Wolfram-Schicht oder einer Wolfram enthaltenden Schicht auf einer Oberfläche eines Substrats
unter Verwendung einer Bis(t*ert*-butylimido)bis(dialkylamido)wolfram-Verbindung gemäß der allgemeinen Formel [W(N*t*Bu)₂(NR^{A}R^{B})₂] (I),
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(*tert*-butylimido)bis(dialkylamido)wolfram-Verbindung [W(N*t*Bu)₂(NMe₂)₂] ausgenommen ist,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
und
b) Abscheidung der Wolfram-Schicht oder der Wolfram enthaltenden Schicht auf der Oberfläche des Substrats.

28. Substrat, welches auf einer Oberfläche eine Wolfram-Schicht oder eine Wolfram enthaltende Schicht aufweist,
wobei die Wolfram-Schicht oder die Wolfram enthaltende Schicht herstellbar ist unter Verwendung einer Bis(*tert*-butylimido)bis(dialkylamido)wolfram-Verbindung gemäß der allgemeinen Formel [W(N*t*Bu)₂(NR^{A}R^{B})₂] (I),
▪ erhalten nach einem Verfahren gemäß einem der Ansprüche 1 bis 21,
oder
▪ erhältlich nach einem Verfahren gemäß einem der Ansprüche 1 bis 21.

29. Substrat, welches auf einer Oberfläche eine Wolfram-Schicht oder eine Wolfram enthaltende Schicht aufweist,
wobei die Wolfram-Schicht oder die Wolfram enthaltende Schicht herstellbar ist unter Verwendung einer Bis(*tert*-butylimido)bis(dialkylamido)wolfram-Verbindung gemäß der allgemeinen Formel [W(N*t*Bu)₂(NR^{A}R^{B})₂] (I),
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(tert-butylimido)bis(dialkylamido)wolfram-Verbindung [W(N*t*Bu)₂(NMe₂)₂] ausgenommen ist.

30. Verwendung einer Bis(*tert*-butylimido)bis(dialkylamido)wolfram-Verbindung gemäß der allgemeinen Formel [W(N*t*Bu)₂(NR^{A}R^{B})₂] (I)
▪ erhalten nach einem Verfahren gemäß einem der Ansprüche 1 bis 21,
oder
▪ erhältlich nach einem Verfahren gemäß einem der Ansprüche 1 bis 21,
zur Herstellung eines elektronischen Bauelementes.

31. Verfahren zur Herstellung eines elektronischen Bauelementes,
unter Verwendung einer Bis(*tert*-butylimido)bis(dialkylamido)wolfram-Verbindung gemäß der allgemeinen Formel [W(N*t*Bu)₂(NR^{A}R^{B})₂] (I)
▪ erhältlich nach einem Verfahren gemäß einem der Ansprüche 1 bis 21,
oder
▪ erhalten nach einem Verfahren gemäß einem der Ansprüche 1 bis 21,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
b) Abscheidung einer Wolfram-Schicht oder einer Wolfram enthaltenden Schicht auf einer Oberfläche eines Substrats,
und
c) Fertigstellung des elektronischen Bauelementes.

32. Verwendung einer Bis(*tert*-butylimido)bis(dialkylamido)wolfram-Verbindung gemäß der allgemeinen Formel [W(N*t*Bu)₂(NR^{A}R^{B})₂] (I)
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(tert-butylimido)bis(dialkylamido)wolfram-Verbindung [W(N*t*Bu)₂(NMe₂)₂] ausgenommen ist,
zur Herstellung eines elektronischen Bauelementes.

33. Verfahren zur Herstellung eines elektronischen Bauelementes,
unter Verwendung einer Bis(*tert*-butylimido)bis(dialkylamido)wolfram-Verbindung gemäß der allgemeinen Formel [W(N*t*Bu)₂(NR^{A}R^{B})₂] (I)
wobei
- R^{A} und R^{B} unabhängig voneinander ausgewählt sind aus der Gruppe bestehend aus linearen und verzweigten Alkylresten mit 1 bis 20 Kohlenstoffatomen,
und
- die Bis(tert-butylimido)bis(dialkylamido)wolfram-Verbindung [W(N*t*Bu)₂(NMe₂)₂] ausgenommen ist,
umfassend die Schritte:
a) Zurverfügungstellung der Bis(*tert*-butylimido)bis(dialkylamido)wolfram-Verbindung gemäß der allgemeinen Formel [W(N*t*Bu)₂(NR^{A}R^{B})₂] (I),
b) Abscheidung einer Wolfram-Schicht oder einer Wolfram enthaltenden Schicht auf einer Oberfläche eines Substrats,
und
c) Fertigstellung des elektronischen Bauelementes.
